# EUROPEAN PATENT APPLICATION

(11) **EP 4 510 223 A1**
(43) Date of publication of application: **19.02.2025**
(21) Application number: 22956150.1
(22) Date of filing: 26.08.2022
(51) Int. Cl.: H01M 4/36, H01M 4/38, H01M 4/62

(54) **SILICON-CARBON COMPOSITE MATERIAL AND PREPARATION METHOD THEREFOR, SECONDARY BATTERY AND ELECTRIC DEVICE**

(71) Applicant: Contemporary Amperex Technology Co., Limited, Ningde, Fujian 352100 (CN)
(72) Inventor: LIU, Liangbin, Ningde, Fujian 352100 (CN); LI, Yuan, Ningde, Fujian 352100 (CN); WANG, Jiazheng, Ningde, Fujian 352100 (CN); LV, Zijian, Ningde, Fujian 352100 (CN); DONG, Xiaobin, Ningde, Fujian 352100 (CN); XIONG, Donggen, Ningde, Fujian 352100 (CN); DENG, Jingxian, Ningde, Fujian 352100 (CN)
(74) Representative: Kraus & Lederer PartGmbB
(86) International application number: PCT/CN2022/115268
(87) International publication number: WO 2024/040605

(57) **Abstract**

This application relates to a silicon-carbon composite material. The silicon-carbon composite material includes a carbon nanotube-and-porous carbon composite substrate and a silicon-based material. The porous carbon is connected to the carbon nanotube by a connecting unit in the carbon nanotube-and-porous carbon composite substrate. The high conductivity and strong mechanical properties of the carbon nanotubes can improve the overall conductivity, compression resistance, and expansion resistance of the silicon-carbon composite material, thereby improving cycle performance, electrode plate cycle expansion resistance, and rate performance of a secondary battery.

## Description

### TECHNICAL FIELD

This application relates to the technical field of secondary batteries, and in particular, to a silicon-carbon composite material and a preparation method thereof, a secondary battery, and an electrical device.

### BACKGROUND

Secondary batteries have now been widely used in the fields such as battery electric vehicles, hybrid electric vehicles, and smart grids. With the ongoing development of the new energy industry, customers have put forward higher requirements on the secondary batteries in use.

Silicon-based negative electrode materials have attracted extensive attention by virtue of a high capacity, but the silicon-based materials incur a severe volume effect, and cause huge volume expansion during charging. The existing silicon-based negative electrode materials are inferior in pressure resistance and electrical conductivity, and are unable to meet electrochemical performance requirements of the batteries.

Therefore, a silicon-based negative electrode material needs to be developed to improve cycle performance, electrode plate cycle expansion resistance, and rate performance of the batteries.

### SUMMARY

In view of the problems described in the background technology, this application provides a silicon-carbon composite to endow a battery with a high level of cycle performance, electrode plate cycle expansion resistance, and rate performance.

A first aspect of this application provides a silicon-carbon composite material. The silicon-carbon composite material includes a carbon nanotube-and-porous carbon composite substrate and a silicon-based material. The porous carbon is connected to the carbon nanotube by a connecting unit in the carbon nanotube-and-porous carbon composite substrate.

In the technical solution in an embodiment of this application, the carbon nanotube and the porous carbon are connected by the connecting unit, and are stably combined into one. The high conductivity of the carbon nanotube can alleviate the problem of low conductivity of the porous carbon, reduce the resistivity of the silicon-carbon composite material, and improve the overall conductivity of the silicon-carbon composite material. The strong mechanical properties of carbon nanotubes can be used to achieve composite reinforcement and make the silicon-carbon composite material be well resistant to compression and expansion, thereby improving the structural stability of the silicon-carbon composite material, and preventing the cycle performance from being deteriorated by particle ruptures caused by expansion and contraction of the silicon-carbon composite material during cold-pressing of the electrode plate or a charge-and-discharge process of the battery. This application can effectively improve the cycle performance, electrode plate cycle expansion resistance, and rate performance of the secondary battery containing the silicon-carbon composite material.

In some embodiments, according to the first aspect, a first example of the first aspect is put forward, in which the connecting unit includes at least one of a carbon-carbon bond, a benzene ring, an ester group, or a carbonyl group.

By optimizing the types of connecting units, the bonding between the carbon nanotube and the porous carbon is reinforced, and the compression resistance of the silicon-carbon composite material is improved.

In some embodiments, according to the first aspect, a second example of the first aspect is put forward, in which at least a part of the silicon-based material is distributed in pores of the carbon nanotube-and-porous carbon composite substrate.

By distributing at least a part of the silicon-based material in the pores of the carbon nanotube-and-porous carbon composite substrate, an expansion space is reserved in the pores of the carbon nanotube-and-porous carbon composite substrate, and can effectively relieve the expansion of the silicon-based material. In addition, by limiting the pore diameter of the porous carbon composite substrate, the particle diameter of the silicon-based material can be limited to a relatively small value (the average particle diameter is less than or equal to 50 nm). Moreover, the porous carbon composite substrate isolates the silicon-based material from an electrolyte solution, thereby effectively improving the cycle performance of the silicon-based material.

In some embodiments, according to the first aspect, a third example of the first aspect is put forward, in which one end of at least a part of the carbon nanotubes protrudes from a surface of the silicon-carbon composite material.

By protruding one end of at least a part of the carbon nanotubes from the surface of the silicon-carbon composite material, the high conductivity of the carbon nanotubes is exerted sufficiently, and therefore, the conductivity of the silicon-carbon composite material is improved.

In some embodiments, according to the first aspect, a fourth example of the first aspect is put forward, in which a diameter of the carbon nanotube is 0.5 to 20 nm. Optionally, the diameter of the carbon nanotube is 0.7 to 10 nm.

When the diameter of the carbon nanotube is smaller, the carbon nanotube possesses higher conductivity and better mechanical properties. However, if the diameter of the carbon nanotube is overly small, the synthesis of the carbon nanotubes is difficult and costly.

In some embodiments, according to the first aspect, a fifth example of the first aspect is put forward, in which a length of the carbon nanotube is denoted as L, and a volume distribution diameter Dv₅₀ of the silicon-carbon composite material is denoted as D₀, and therefore, the silicon-carbon composite material satisfies: L ≥ 3D₀. Optionally, the silicon-carbon composite material satisfies: 3D₀ ≤ L ≤ 7D₀.

When the length of the carbon nanotubes satisfies the above formula, it is ensured that the carbon nanotubes are spread throughout the entire particle of the silicon-carbon composite material, thereby sufficiently exerting the conductivity and mechanical properties of the carbon nanotubes, and in turn, improving the overall conductivity and compression resistance of the silicon-carbon composite material.

In some embodiments, according to the first aspect, a sixth example of the first aspect is put forward, in which a length-to-diameter ratio of the carbon nanotube is greater than or equal to 900, and optionally is 2500 to 25000.

In some embodiments, according to the first aspect, a seventh example of the first aspect is put forward, in which a content of the carbon nanotubes in the silicon-carbon composite material is less than or equal to 8%, and optionally is 0.2% to 5.0%.

When the content of the carbon nanotubes is deficient, the conductivity of the silicon-carbon composite material cannot be effectively improved. When the content of the carbon nanotubes is excessive, the cost will be increased, and the dispersion and processing effect will be impaired.

In some embodiments, according to the first aspect, an eighth example of the first aspect is put forward, in which the carbon nanotube-and-porous carbon composite substrate satisfies at least one of the following conditions (1) to (4):
(1) the carbon nanotube-and-porous carbon composite substrate includes mesopores inside, and optionally, a pore volume of the mesopores is greater than or equal to 0.1 cm³/g, and further optionally is 0.2 to 2.5 cm³/g;
(2) the carbon nanotube-and-porous carbon composite substrate includes micropores inside, and optionally, a pore volume of the micropores is less than or equal to 0.3 cm³/g, and further optionally is 0.05 to 0.2 cm³/g;
(3) the carbon nanotube-and-porous carbon composite substrate includes macropores inside, and optionally, a pore volume of the macropores is less than or equal to 0.5 cm³/g, and further optionally is 0.05 to 0.4 cm³/g; and
(4) the carbon nanotube-and-porous carbon composite substrate includes mesopores and micropores inside, and optionally, a pore volume ratio between the mesopores and the micropores is greater than or equal to 2, and optionally is 3 to 15.

By optimizing the pores inside the carbon nanotube-and-porous carbon composite substrate, the particle size of the silicon-based material can be conveniently limited to a relatively small value (the average particle diameter is less than or equal to 50 nm), and the composite material can be conveniently isolated from the electrolyte solution. In addition, the amount of micropores/mesopores/macropores is limited to a specified range so that an expansion space can be reserved. Through the above beneficial effects, the expansion resistance and cycle performance of the silicon-carbon composite material are improved.

In some embodiments, according to the first aspect, a ninth example of the first aspect is put forward, in which the silicon-based material is nano-silicon-based particles. Optionally, an average particle diameter of the nano-silicon-based particles is less than or equal to 50 nm, and further optionally is 3 to 20 nm.

An excessive particle size of the nano-silicon-based particles will lead to excessive expansion in a local region caused by charging, thereby impairing the structural stability of the silicon-carbon composite material, and in turn, impairing the cycle performance of the silicon-carbon composite material.

In some embodiments, according to the first aspect, a tenth example of the first aspect is put forward, in which the silicon-based material includes at least one of simple-substance silicon, silicon oxide (such as silicon suboxide), a silicon-carbon composite, a silicon-nitrogen composite, a silicon alloy, or a pre-lithiated silicon oxide compound.

By further optimizing the types of the silicon-based materials, the capacity of the silicon-carbon composite material is further increased, and therefore, the energy density of the battery is increased.

In some embodiments, according to the first aspect, an eleventh example of the first aspect is put forward, in which the silicon-based material includes amorphous silicon. Optionally, the silicon-based material includes a mixture of amorphous silicon and crystalline silicon.

By optimizing the types of the silicon-based materials, the capacity of the silicon-carbon composite material is increased, and therefore, the energy density of the battery is increased.

In some embodiments, according to the first aspect, a twelfth example of the first aspect is put forward, in which the carbon nanotube-and-porous carbon composite substrate is formed by carbonizing a resin precursor and carbon nanotubes grafted with a functional group and/or a polymer. Both the functional group and the polymer are able to chemically react with the resin precursor to connect the carbon nanotubes and the resin precursor to form the connecting unit after carbonization.

Because both the functional group and the polymer are able to chemically react with the resin precursor to chemically connect the carbon nanotubes and the resin precursor to form the connecting unit after carbonization, the interfacial bonding between carbon nanotube and the resin is strengthened, and therefore, the compression resistance of silicon-carbon composite material is increased.

In some embodiments, according to the first aspect, a thirteenth example of the first aspect is put forward, in which, when the silicon-carbon composite material or the carbon nanotube-and-porous carbon composite substrate is tested by infrared spectroscopy, the silicon-carbon composite material or the carbon nanotube-and-porous carbon composite substrate includes at least one of the following connecting units: ester carbonyl with an absorption peak of 1750 to 1735 cm⁻¹, ketone carbonyl with an absorption peak of 1725 to 1705 cm⁻¹, a phenyl ring group with an absorption peak of 1620 to 1450 cm⁻¹, or a carbon-carbon bond with an absorption peak of 2400 to 1950 cm⁻¹; and/or, when the silicon-carbon composite material or the carbon nanotube-and-porous carbon composite substrate is tested by a transmission electron microscope, a region percentage is greater than or equal to 50%, where the region percentage is a length percentage of a region meeting the following criterion: an inter-atom spacing of the carbon nanotube in the silicon-carbon composite material or the carbon nanotube-and-porous carbon composite substrate is less than or equal to 0.35 nm, and the inter-atom spacing is a spacing between a carbon atom around the carbon nanotube and a carbon atom in an outermost layer of the carbon nanotube.

The infrared spectroscopy test shows that the silicon-carbon composite material or carbon nanotube-and-porous carbon composite substrate contains a connecting unit. The transmission electron microscope test shows that the porous carbon and the carbon nanotube are connected together. Such characterization results indicate that the porous carbon and the carbon nanotube are connected as a whole by the connecting unit, and interfacial bonding is strengthened.

In some embodiments, according to the first aspect, a fourteenth example of the first aspect is put forward, in which, a compression resistance index of the silicon-carbon composite material is expressed as P = D₀/(D₀-D₁), and P is greater than or equal to 3. In the relational expression, D₀ is a volume distribution diameter Dv₅₀ of the silicon-carbon composite material, D₁ is a volume distribution diameter Dv₅₀ of the silicon-carbon composite material that has been compressed for 50 times. In a compression operation performed in each time, the silicon-carbon composite material is compressed under a pressure of 300 MPa for 30 seconds.

The compression resistance index P greater than or equal to 3 indicates that the silicon-carbon composite material is well resistant to compression, and can well alleviate the expansion problem of the silicon-based material, and endow the silicon-carbon composite material with excellent cycle performance.

In some embodiments, according to the first aspect, a fifteenth example of the first aspect is put forward, in which a resistivity ρ of the silicon-carbon composite material under a pressure of 4 MPa is less than or equal to 0.4 Ω·cm, and optionally satisfies: 0.05 Ω·cm ≤ ρ ≤ 0.3 Ω·cm.

When the resistivity of the silicon-carbon composite material under a 4 MPa pressure is lower, the conductivity of the silicon-carbon composite material is higher. By optimizing the resistivity of silicon-carbon composite material, the conductivity is improved.

In some embodiments, according to the first aspect, a sixteenth example of the first aspect is put forward, in which the silicon-carbon composite material satisfies at least one of the following conditions (I) to (V):
(I) a volume distribution diameter Dv₅₀ of the silicon-carbon composite material is less than or equal to 8 µm, and optionally is 3 to 7 µm;
(II) a porosity of the silicon-carbon composite material is less than or equal to 20%, and optionally is 5% to 15%;
(III) a specific surface area SSA of the silicon-carbon composite material is less than or equal to 5.0 m²/g, and optionally is 0.8 to 4.0 m²/g;
(IV) the silicon-carbon composite material includes mesopores inside, and optionally, a pore volume of the mesopores is less than or equal to 0.3 cm³/g, and further optionally is 0.05 to 0.1 cm³/g; and
(V) a mass ratio between elements in the silicon-carbon composite material is Si: C: O = (20 to 55): (40 to 70): (3 to 10).

By optimizing the particle size of the silicon-carbon composite material, the cycle performance deterioration caused by a small particle size is avoided, and the conductivity decrease caused by a large particle size is avoided. By reserving a specified porosity inside the silicon-carbon composite material, an expansion space is reserved for the silicon-based material that expands during charging, the expansion can be cushioned, and the cycle performance of the material is improved. When the specific surface area of the silicon-carbon composite material is excessively large, the performance of the material is impaired. When the specific surface area of the silicon-carbon composite material is excessively small, the specific surface area can hardly be implemented in the porous carbon material. When the pore volume of the mesopores in the silicon-carbon composite material is excessively small, the reserved expansion space of the silicon-based material will be insufficient, and the cycle performance of the silicon-carbon composite material will be impaired. When the pore volume of the mesopores in the silicon-carbon composite material is excessively large, the volume energy density of the silicon-carbon composite material will be excessively low, the practicability of the material will be reduced. In addition, when the pore volume of the mesopores in the silicon-carbon composite material is excessively large, the compression resistance of the silicon-carbon composite material will be impaired, and the material is not resistant to pressure. By optimizing the silicon content, it is ensured that the requirement on the capacity of the silicon-carbon composite material is satisfied. By optimizing the carbon content, it is ensured that the porous carbon is formed effectively, and it is ensured that the subsequently deposited silicon-based material is isolated effectively. By optimizing the oxygen content, the pliability of the porous carbon is ensured, and the stability of connection of the porous carbon to the silicon-based material and the carbon nanotube is ensured.

In some embodiments, according to the first aspect, a seventeenth example of the first aspect is put forward, in which a coating layer is further disposed on a surface of the silicon-carbon composite material. Optionally, the coating layer includes at least one of a carbon coating layer, a polymer coating layer, an inorganic salt coating layer, or a metal oxide coating layer.

By forming a coating layer on the surface of the silicon-carbon composite material, it is more convenient to prevent direct contact between the electrolyte solution and the silicon-carbon composite material, and improve the cycle performance. In addition, the coating layer serves a function of cushioning to some extent, and further cushions the expansion and reduces the impact of expansion on the electrode plate. Especially, a carbon coating layer can further improve the conductivity of the silicon carbon material.

A second aspect of this application provides a method for preparing a silicon-carbon composite material, including the following steps:
grafting a functional group and/or a polymer onto a carbon nanotube to obtain a modified carbon nanotube;
mixing the modified carbon nanotube with a resin precursor solution to obtain a mixed solution, where both the functional group and the polymer on the modified carbon nanotube is able to chemically react with the resin precursor to connect the modified carbon nanotube and the resin precursor;
curing the mixed solution to obtain a composite substrate precursor;
carbonizing the composite substrate precursor to obtain a porous carbon-and-carbon nanotube composite substrate; and
depositing a silicon-based material on the porous carbon-and-carbon nanotube composite substrate to obtain a silicon-carbon composite material.

Based on the technical solution in an embodiment of this application, the above method can achieve a silicon-carbon composite material that is superior in compression resistance and conductivity. The method is simple to operate, easily repeatable, and mass-producible in industrial applications.

In some embodiments, according to the second aspect, a first example of the second aspect is put forward, in which the mixed solution further includes a catalyst at a percentage of 0.5% to 30% by mass. Optionally, the catalyst includes one or more of hexamethylenetetramine, ammonium bicarbonate, ammonium carbonate, ammonia, a zinc salt, a copper salt, or a chromium salt.

By optimizing the reaction conditions, the time of reaction between the modified carbon nanotube and the resin precursor can be shortened favorably, and the reaction conversion rate is improved.

In some embodiments, according to the second aspect, a second example of the second aspect is put forward, in which the mixing includes: stirring at 20 °C to 60 °C for 1 to 10 hours. In this way, the modified carbon nanotube reacts with the resin precursor in one or more of the following manners: esterification reaction, addition reaction, polyaddition reaction, or polycondensation reaction.

In some embodiments, according to the second aspect, a first example of the second aspect is put forward, in which the functional group includes one or more of carboxyl, hydroxyl, amino, phenyl, or carbonyl; and/or, the polymer includes one or more of polyamide, polymethyl methacrylate, or polyhydroxyethyl methacrylate.

By optimizing the types of functional groups and/or polymers grafted onto carbon nanotubes, it is convenient to form a more stable connecting unit between the carbon nanotube and the porous carbon, strengthen the interfacial bonding, and improve the compression resistance of the silicon-carbon composite material.

In some embodiments, according to the second aspect, a fourth example of the second aspect is put forward, in which the curing includes: pre-curing, and full curing. Optionally, the curing includes: pre-curing, pulverizing, and full curing.

By optimizing the curing process, the curing effect is improved, and the internal uniformity of the silicon-carbon composite material is improved.

In some embodiments, according to the second aspect, a fifth example of the second aspect is put forward, in which the pre-curing is performed at a temperature of 70 °C to 140 °C, and optionally 80 °C to 130 °C; and/or the pre-curing continues for a time period of 3 to 12 hours, and optionally 5 to 10 hours.

By optimizing the temperature and time of pre-curing, the internal uniformity of the silicon-carbon composite material is improved, and the uniformity of pore distribution and pore size is improved.

In some embodiments, according to the second aspect, a sixth example of the second aspect is put forward, in which the full curing is performed at a temperature of 150 °C to 220 °C, and optionally 160 °C to 200 °C; and/or the full curing continues for a time period of 8 to 20 hours, and optionally 10 to 15 hours.

By optimizing the temperature and time of full curing, the curing effect is improved, and the internal uniformity of the silicon-carbon composite material is improved.

In some embodiments, according to the second aspect, a seventh example of the second aspect is put forward, in which the carbonization is performed at a temperature of 900 °C to 3000 °C, and optionally 1000 °C to 2000 °C; and/or the carbonization continues for a time period of 2 to 6 hours, and optionally 3 to 5 hours.

By optimizing the temperature and time of carbonization, it is convenient to form a more stable connecting unit between the carbon nanotube and the porous carbon, strengthen the interfacial bonding, and improve the compression resistance of the silicon-carbon composite material.

In some embodiments, according to the second aspect, an eighth example of the second aspect is put forward, in which the deposition is performed by a chemical vapor deposition method. Optionally, a deposition gas includes a mixed gas formed by mixing a silane gas with at least one of H₂, N₂, or Ar.

The silicon deposition performed by a chemical vapor deposition method makes it convenient to evenly deposit the silicon-based material in the porous carbon-and-carbon nanotube composite substrate. In addition, the growth of silicon particles is limited by the pore size of the porous carbon, and the chemical vapor deposition method can limit the particle size of the silicon particles to a relatively small value, for example, limit the average particle diameter to 50 nm. On the other hand, the chemical vapor deposition method can implement close bonding between the porous carbon and the deposited silicon-based material, thereby properly limiting the expansion of the silicon material.

A third aspect of this application provides a secondary battery. The secondary battery includes a negative electrode plate. The negative electrode plate includes the silicon-carbon composite material according to the first aspect of this application or a silicon-carbon composite material prepared by the preparation method according to the second aspect of this application.

In the technical solution in an embodiment of this application, the silicon-carbon composite material according to the first aspect of this application or a silicon-carbon composite material prepared by the preparation method according to the second aspect of this application is employed, and therefore, the secondary battery of this application achieves improved cycle performance.

A fourth aspect of this application provides an electrical device. The electrical device includes the secondary battery according to the third aspect of this application.

In the technical solution in an embodiment of this application, the silicon-carbon composite material according to the first aspect of this application or a silicon-carbon composite material prepared by the preparation method according to the second aspect of this application is employed, and therefore, the electrical device of this application achieves improved cycle performance.

The foregoing description is merely an overview of the technical solutions of this application. Some specific embodiments of this application are described below illustratively to enable a clearer understanding of the technical solutions of this application, enable implementation of the technical solutions based on the subject-matter hereof, and make the foregoing and other objectives, features, and advantages of this application more evident and comprehensible.

### BRIEF DESCRIPTION OF DRAWINGS

By reading the following detailed description of exemplary embodiments, a person of ordinary skill in the art becomes clearly aware of various other advantages and benefits. The drawings are merely intended to illustrate the exemplary embodiments, but not to limit this application. In all the drawings, the same reference numeral represents the same component. In the drawings:
FIG. 1 is a schematic structural diagram of a silicon-carbon composite material according to this application;
FIG. 2 is a scanning electron microscope (SEM) image of a silicon-carbon composite material according to this application;
FIG. 3 is a schematic diagram of a secondary battery according to an embodiment;
FIG. 4 is an exploded view of FIG. 3;
FIG. 5 is a schematic diagram of a battery module according to an embodiment;
FIG. 6 is a schematic diagram of a battery pack according to an embodiment;
FIG. 7 is an exploded view of FIG. 6; and
FIG. 8 is a schematic diagram of a device using a secondary battery as a power supply according to an embodiment.

### List of reference numerals:

1. battery pack; 2. upper box; 3. lower box; 4. battery module; 5. secondary battery; 51. housing; 52. electrode assembly; 53. cover plate.

### DETAILED DESCRIPTION OF EMBODIMENTS

The following describes exemplary embodiments of the present disclosure in more detail with reference to drawings. Understandably, although the exemplary embodiments of the present disclosure are shown in the drawings, the present disclosure may be implemented in various forms, without being limited to the embodiments expounded herein. Such embodiments are provided to enable a more thorough understanding of the present disclosure and to fully convey the scope of the present disclosure to a person skilled in the art.

Unless otherwise defined, all technical and scientific terms used herein have the same meanings as what is normally understood by a person skilled in the technical field of this application. The terms used herein are merely intended to describe specific embodiments but not to limit this application. The terms "include" and "contain" and any variations thereof used in the specification, claims, and brief description of drawings of this application are intended to cover a non-exclusive inclusion.

For brevity, just some of numerical ranges are expressly disclosed herein. However, any lower limit may be combined with any upper limit to form an unspecified range, any lower limit may be combined with any other lower limit to form an unspecified range, and any upper limit may be combined with any other upper limit to form an unspecified range. In addition, although not explicitly stated, any point and any single numerical value between end points of a range are included in the range. Therefore, each point or each single numerical value may be used as a lower limit or upper limit of the range to combine with any other point or other single numerical value or with any other lower or upper limit to form an unspecified range.

It is hereby noted that in the context herein, unless otherwise specified, a range defined by a numerical value qualified by "at least" or "at most" includes this numerical value, and the word "more" in the phrase "one or more of" means at least two (inclusive).

In the description of an embodiment of this application, unless otherwise expressly specified and defined, the technical term "connection" means bonding of two chemical substances through a connecting unit. A person of ordinary skill in the art can understand the specific meanings of the terms in the embodiments of this application according to specific situations.

The above summary of this application is not intended to describe every disclosed embodiment or every implementation of this application. The following description exemplifies illustrative embodiments in more detail. In several places throughout this application, guidance is provided through a series of embodiments. The embodiments may be used in various combinations. In each instance, an enumerated list serves merely as a representative list, but is not to be construed as an exclusive list.

Silicon-based negative electrode materials have attracted extensive attention by virtue of a high capacity, but the silicon-based materials incur a severe volume effect, and cause huge volume expansion during charging. In view of this, researchers have developed a silicon-carbon negative electrode material. However, the existing silicon-carbon negative electrode material is not much resistant to pressure, and the structure of the material is prone to be destroyed during practical cold-pressing of an electrode plate, thereby impairing the electrochemical performance of the material. In addition, the existing silicon-carbon negative electrode material is of high resistivity and low conductivity, and is unable to meet the requirements on the electrochemical performance of the material. Therefore, a silicon-based negative electrode material urgently needs to be developed to improve cycle performance, electrode plate cycle expansion resistance, and rate performance of the batteries.

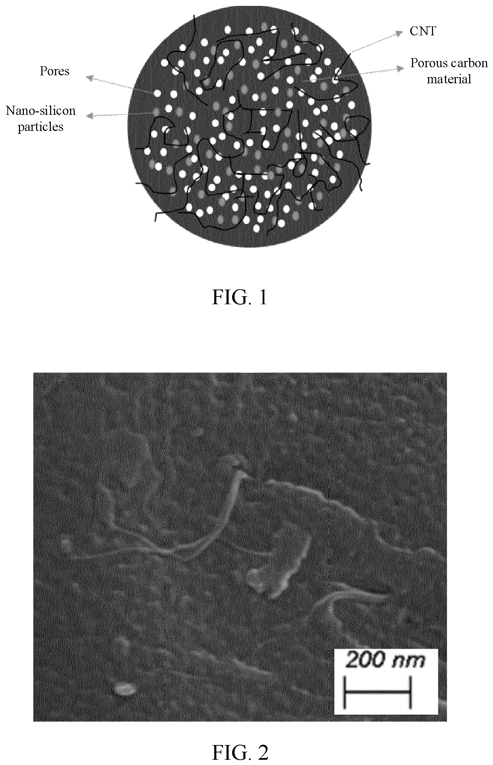

Through in-depth research, the inventor hereof has designed a silicon-carbon composite material. Referring to FIG. 1, the silicon-carbon composite material includes a carbon nanotube-and-porous carbon composite substrate and a silicon-based material. The porous carbon is connected to the carbon nanotube by a connecting unit in the carbon nanotube-and-porous carbon composite substrate.

In the technical solution in an embodiment of this application, the carbon nanotube and the porous carbon are connected by the connecting unit, and are stably combined into one. The high conductivity of the carbon nanotube can alleviate the problem of low conductivity of the porous carbon, reduce the resistivity of the silicon-carbon composite material, and improve the overall conductivity of the silicon-carbon composite material. The strong mechanical properties of carbon nanotubes can be used to achieve composite reinforcement and make the silicon-carbon composite material be well resistant to compression, and in turn, well resistant to expansion, thereby improving the structural stability of the silicon-carbon composite material, and preventing the cycle performance from being deteriorated by particle ruptures during cold-pressing of the electrode plate. This application can effectively improve the cycle performance, electrode plate cycle expansion resistance, and rate performance of the secondary battery containing the silicon-carbon composite material.

In some embodiments, the connecting unit includes at least one of a carbon-carbon bond, a benzene ring, an ester group, or a carbonyl group.

By optimizing the types of connecting units, the bonding between the carbon nanotube and the porous carbon is reinforced, and the compression resistance of the silicon-carbon composite material is improved.

However, the type of the connecting unit is not limited to the examples enumerated above. Any and all connecting units capable of chemically connecting the carbon nanotube to the porous carbon fall within in the scope of this application, and are not be listed here exhaustively.

In some embodiments, at least a part of the silicon-based material is distributed in pores of the carbon nanotube-and-porous carbon composite substrate.

By distributing at least a part of the silicon-based material in the pores of the carbon nanotube-and-porous carbon composite substrate, an expansion space is reserved in the pores of the carbon nanotube-and-porous carbon composite substrate, and can effectively relieve the expansion of the silicon-based material. In addition, by limiting the pore diameter of the porous carbon composite substrate, the particle diameter of the silicon-based material can be limited to a relatively small value (for example, the average particle diameter is less than or equal to 50 nm). Moreover, the porous carbon composite substrate isolates the silicon-based material from an electrolyte solution, thereby effectively improving the cycle performance of the silicon-based material.

In some embodiments, referring to FIG. 2, one end of at least a part of the carbon nanotubes protrudes from a surface of the silicon-carbon composite material.

By protruding one end of at least a part of the carbon nanotubes from the surface of the silicon-carbon composite material, the design facilitates contact between the carbon nanotube and an electrolyte solution, exerts the high conductivity of the carbon nanotube sufficiently, and therefore, improves the conductivity of the silicon-carbon composite material. If the carbon nanotube is fully wrapped in the porous carbon, the carbon nanotube is unable to be in good contact with the electrolyte solution. Therefore, the conductivity of the carbon nanotube is not exerted sufficiently, and the conductivity of the silicon-carbon composite material is not improved favorably.

In some embodiments, the diameter of the carbon nanotube may be 0.5 to 20 nm. Optionally, the diameter of the carbon nanotube may be 0.7 to 10 nm.

When the diameter of the carbon nanotube is smaller, the carbon nanotube possesses higher conductivity and better mechanical properties. However, if the diameter of the carbon nanotube is overly small, the synthesis of the carbon nanotubes is difficult and costly.

In some embodiments, the diameter of the carbon nanotube may be 0.5 nm, 0.7 nm, 1 nm, 2 nm, 3 nm, 4 nm, 5 nm, 6 nm, 7 nm, 8 nm, 9 nm, 10 nm, 11 nm, 12 nm, 13 nm, 14 nm, 15 nm, 16 nm, 17 nm, 18 nm, 19 nm, or 20 nm. Optionally, the diameter of the carbon nanotube may be 0.7 to 6 nm. The diameter of the carbon nanotube may be a value falling within a range formed by any two of the values listed above.

In some embodiments, a length of the carbon nanotube is denoted as L, and a volume distribution diameter Dv₅₀ of the silicon-carbon composite material is denoted as D₀, and therefore, the silicon-carbon composite material satisfies: L ≥ 3D₀. Optionally, the silicon-carbon composite material satisfies: 3D₀ ≤ L ≤ 7D₀.

When the length of the carbon nanotubes satisfies the above formula, it is ensured that the carbon nanotubes are spread throughout the entire particle of the silicon-carbon composite material, thereby sufficiently exerting the conductivity and mechanical properties of the carbon nanotubes, and in turn, improving the overall conductivity and compression resistance of the silicon-carbon composite material. In addition, when the length of the carbon nanotube is ensured to be greater than the volume distribution diameter of the silicon-carbon composite material, it is convenient for one end of at least a part of the carbon nanotube to protrude from the surface of the silicon-carbon composite material. When the carbon nanotube is overly short, the carbon nanotube is prone to be wrapped in the porous carbon, and can hardly contact the electrolyte solution, and in turn, can hardly exert the high conductivity of the carbon nanotube.

In some embodiments, L may be 3D₀, 3.5D₀, 4D₀, 4.5D₀, 5D₀, 5.5D₀, 6D₀, 6.5D₀, or 7D₀.

In some embodiments, a length-to-diameter ratio of the carbon nanotube is greater than or equal to 900, and optionally is 2500 to 25000.

In some embodiments, the length-to-diameter ratio of the carbon nanotube may be 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000, 23000, 24000, or 25000. The length-to-diameter ratio of the carbon nanotube may be a value falling within a range formed by any two of the values listed above.

In some embodiments, a content of the carbon nanotubes in the silicon-carbon composite material is less than or equal to 8%, and optionally is 0.2% to 5.0%.

When the content of the carbon nanotubes is deficient, the conductivity of the silicon-carbon composite material cannot be effectively improved. When the content of the carbon nanotubes is excessive, the cost will be increased, and the dispersion and processing effect will be impaired.

In some embodiments, the content of the carbon nanotubes in the silicon-carbon composite material may be 0.2%, 0.3%, 0.5%, 1.0%, 1.5%, 2.0%, 2.5%, 3.0%, 3.5%, 4.0%, 4.5%, 5.0%, 5.5%, 6.0%, 6.5%, 7.0%, 7.5%, or 8.0%. The content of the carbon nanotubes in the silicon-carbon composite material may be a value falling within a range formed by any two of the values listed above.

In some embodiments, the carbon nanotube-and-porous carbon composite substrate includes mesopores inside. Optionally, a pore volume of the mesopores is greater than or equal to 0.1 cm³/g, for example, is 0.2 to 2.5 cm³/g.

In some embodiments, the pore volume of the mesopores may be 0.1 cm³/g, 0.2 cm³/g, 0.5 cm³/g, 1.0 cm³/g, 1.5 cm³/g, 2.0 cm³/g, or 2.5 cm³/g. The pore volume of the mesopores may be a value falling within a range formed by any two of the values listed above.

In some embodiments, the carbon nanotube-and-porous carbon composite substrate includes micropores inside. Optionally, a pore volume of the micropores is less than or equal to 0.3 cm³/g, for example, is 0.05 to 0.2 cm³/g.

In some embodiments, the pore volume of the micropores may be 0.05 cm³/g, 0.1 cm³/g, 0.15 cm³/g, 0.2 cm³/g, 0.25 cm³/g, or 0.3 cm³/g. The pore volume of the micropores may be a value falling within a range formed by any two of the values listed above.

In some embodiments, the carbon nanotube-and-porous carbon composite substrate includes macropores inside. Optionally, a pore volume of the macropores is less than or equal to 0.5 cm³/g, for example, is 0.05 to 0.4 cm³/g.

In some embodiments, the pore volume of the macropores may be 0.05 cm³/g, 0.1 cm³/g, 0.15 cm³/g, 0.2 cm³/g, 0.25 cm³/g, 0.3 cm³/g, 0.35 cm³/g, 0.4 cm³/g, 0.45 cm³/g, or 0.5 cm³/g. The pore volume of the macropores may be a value falling within a range formed by any two of the values listed above.

In some embodiments, the carbon nanotube-and-porous carbon composite substrate includes mesopores and micropores inside. Optionally, a pore volume ratio between the mesopores and the micropores is greater than or equal to 2, for example, is 3 to 15.

In some embodiments, a ratio of the pore volume of mesopores to the pore volume of micropores may be 2, 3, 4, 5, 6, 7, 8, 9, 10, 11, 12, 13, 14, or 15. The ratio of the pore volume of mesopores to the pore volume of micropores may be a value falling within a range formed by any two of the values listed above.

In some embodiments, the porosity of the carbon nanotube-and-porous carbon composite substrate is greater than or equal to 20%, and optionally, is 20% to 60%.

In some embodiments, the average pore diameter of the carbon nanotube-and-porous carbon composite substrate is 1 to 100 nm, and optionally, 5 to 50 nm.

By optimizing the pores inside the carbon nanotube-and-porous carbon composite substrate, the particle size of the silicon-based material can be conveniently limited to a relatively small value (for example, the average particle diameter is less than or equal to 50 nm), and the composite material can be conveniently isolated from the electrolyte solution. In addition, the amount of micropores/mesopores/macropores is limited to a specified range so that an expansion space can be reserved. Through the above beneficial effects, the expansion resistance and cycle performance of the silicon-carbon composite material are improved.

In some embodiments, the mass percent of the carbon nanotubes in the carbon nanotube-and-porous carbon composite substrate may be 0.05% to 16%, and optionally, 0.1% to 10%, for example, may be 0.05%, 0.1%, 0.2%, 0.5%, 1%, 2%, 3%, 4%, 5%, 6%, 7%, 8%, 9%, 10%, 11%, 12%, 13%, 14%, or 15%. The mass percent of the carbon nanotubes in the carbon nanotube-and-porous carbon composite substrate may be a value falling within a range formed by any two of the values listed above.

In some embodiments, the silicon-based material is nano-silicon-based particles. Optionally, an average particle diameter of the nano-silicon-based particles is less than or equal to 50 nm, and further optionally is 3 to 20 nm.

The applicant finds that an excessive particle size of the nano-silicon-based particles will lead to excessive expansion in a local region caused by charging, thereby impairing the structural stability of the silicon-carbon composite material, and in turn, impairing the cycle performance of the silicon-carbon composite material.

In some embodiments, the average particle diameter of the nano-silicon-based particles may be 3 nm, 4 nm, 5 nm, 6 nm, 7 nm, 8 nm, 9 nm, 10 nm, 11 nm, 12 nm, 13 nm, 14 nm, 15 nm, 16 nm, 17 nm, 18 nm, 19 nm, 20 nm, 25 nm, 30 nm, 35 nm, 40 nm, 45 nm, or 50 nm. The average particle diameter of the nano-silicon-based particles may be a value falling within a range formed by any two of the values listed above.

In some embodiments, the silicon-based material includes at least one of simple-substance silicon, silicon oxide (such as silicon suboxide), a silicon-carbon composite, a silicon-nitrogen composite, a silicon alloy, or a pre-lithiated silicon oxide compound.

In some embodiments, the silicon-based material includes amorphous silicon. Optionally, the silicon-based material includes a mixture of amorphous silicon and crystalline silicon.

By further optimizing the types of the silicon-based materials, the capacity of the silicon-carbon composite material is further increased, and therefore, the energy density of the battery is increased.

In some embodiments, the carbon nanotube-and-porous carbon composite substrate is formed by carbonizing a resin precursor and carbon nanotubes grafted with a functional group and/or a polymer. Both the functional group and the polymer are able to chemically react with the resin precursor to connect the carbon nanotubes and the resin precursor to form the connecting unit after carbonization.

Because both the functional group and the polymer are able to chemically react with the resin precursor to chemically connect the carbon nanotubes and the resin precursor to form the connecting unit after carbonization, the interfacial bonding between carbon nanotube and the resin is strengthened, and therefore, the compression resistance of silicon-carbon composite material is increased.

In some embodiments, the functional group may be one or more of carboxyl, hydroxyl, amino, phenyl, or carbonyl. The polymer may be one or more of polyamide, polymethyl methacrylate, or polyhydroxyethyl methacrylate.

In some embodiments, when the silicon-carbon composite material or the carbon nanotube-and-porous carbon composite substrate is tested by infrared spectroscopy, the silicon-carbon composite material or the carbon nanotube-and-porous carbon composite substrate includes at least one of the following connecting units: ester carbonyl with an absorption peak of 1750 to 1735 cm⁻¹, ketone carbonyl with an absorption peak of 1725 to 1705 cm⁻¹, a phenyl ring group with an absorption peak of 1620 to 1450 cm⁻¹, or a carbon-carbon bond with an absorption peak of 2400 to 1950 cm⁻¹.

In some embodiments, when the silicon-carbon composite material or the carbon nanotube-and-porous carbon composite substrate is tested by a transmission electron microscope, a region percentage is greater than or equal to 50%, where the region percentage is a length percentage of a region meeting the following criterion: an inter-atom spacing of the carbon nanotube in the silicon-carbon composite material or the carbon nanotube-and-porous carbon composite substrate is less than or equal to 0.35 nm, and the inter-atom spacing is a spacing between a carbon atom around the carbon nanotube and a carbon atom in an outermost layer of the carbon nanotube. This indicates that the porous carbon and the carbon nanotube are connected together. The "region percentage" here means a ratio of an effective length of a carbon nanotube meeting a criterion to an actual length of the carbon nanotube, where the criterion is: an inter-atom spacing of the carbon nanotube is less than or equal to 0.35 nm, and the inter-atom spacing is a spacing between a carbon atom around the carbon nanotube and a carbon atom in an outermost layer of the carbon nanotube. The meaning of "region percentage" is a percentage of the length of a connection region with a connecting unit between the carbon nanotube and the porous carbon in relation to the aggregate length of the carbon nanotube. A larger value of the region percentage means a closer connection between the carbon nanotube and the porous carbon. When the region percentage is greater than 50%, it is deemed that the carbon nanotube and the porous carbon are connected together by an effective connecting unit.

The infrared spectroscopy test shows that the silicon-carbon composite material or carbon nanotube-and-porous carbon composite substrate contains a connecting unit. The transmission electron microscope test shows that the porous carbon and the carbon nanotube are connected together. Such characterization results indicate that the porous carbon and the carbon nanotube are connected as a whole by the connecting unit, and interfacial bonding is strengthened, thereby effectively improving the overall compression resistance of the silicon-carbon composite material.

In some embodiments, a compression resistance index of the silicon-carbon composite material is expressed as P = D₀/(D₀-D₁), and P is greater than or equal to 3. In the relational expression, D₀ is a volume distribution diameter Dv₅₀ of the silicon-carbon composite material, D₁ is a volume distribution diameter Dv₅₀ of the silicon-carbon composite material that has been compressed for 50 times. In a compression operation performed in each time, the silicon-carbon composite material is compressed under a pressure of 300 MPa for 30 seconds.

The compression resistance index P greater than or equal to 3 indicates that the silicon-carbon composite material is well resistant to compression, and can well alleviate the expansion problem of the silicon-based material, and endow the silicon-carbon composite material with excellent cycle performance.

Optionally, 5 ≤ P ≤ 100. A larger value of P means a smaller impact of the compression on the particle size of the material and a higher compression resistance of the silicon-carbon composite material.

In some embodiments, the value of P may be 3, 5, 10, 15, 20, 25, 30, 35, 40, 45, 50, 55, 60, 65, 70, 75, 80, 85, 90, 95, or 100. P may be a value falling within a range formed by any two of the values listed above.

In some embodiments, a resistivity ρ of the silicon-carbon composite material under a pressure of 4 MPa is less than or equal to 0.4 Ω·cm, and optionally satisfies: 0.05 Ω·cm ≤ ρ < 0.3 Ω·cm.

When the resistivity of the silicon-carbon composite material under a 4 MPa pressure is lower, the conductivity of the silicon-carbon composite material is higher. By optimizing the resistivity of silicon-carbon composite material, the conductivity is improved.

In some embodiments, ρ may be 0.05 Ω·cm, 0.1 Ω·cm, 0.15 Ω·cm, 0.2 Ω·cm, 0.25 Ω·cm, 0.3 Ω·cm, 0.35 Ω·cm, or 0.4 Ω·cm. The resistivity ρ may be a value falling within a range formed by any two of the values listed above.

In some embodiments, the volume distribution diameter Dv₅₀ of the silicon-carbon composite material is less than or equal to 8 µm, and optionally is 3 to 7 µm. In some embodiments, the volume distribution diameter Dv₅₀ of the silicon-carbon composite material may be 3 µm, 3.5 µm, 4 µm, 4.5 µm, 5 µm, 5.5 µm, 6 µm, 6.5 µm, 7 µm, 7.5 µm, or 8 µm. The volume distribution diameter Dv₅₀ of the silicon-carbon composite material may be a value falling within a range formed by any two of the values listed above. By optimizing the particle size of the silicon-carbon composite material, the cycle performance deterioration caused by a small particle size is avoided, and the conductivity decrease caused by a large particle size is avoided.

In some embodiments, a porosity of the silicon-carbon composite material is less than or equal to 20%, and optionally is 5% to 15%. In some embodiments, the porosity of the silicon-carbon composite material may be 5%, 6%, 7%, 8%, 9%, 10%, 11%, 12%, 13%, 14%, 15%, 16%, 17%, 18%, 19%, or 20%. The porosity of the silicon-carbon composite material may be a value falling within a range formed by any two of the values listed above. By reserving a specified porosity inside the silicon-carbon composite material, an expansion space is reserved for the silicon-based material that expands during charging, the expansion can be cushioned, and the cycle performance of the material is improved.

In some embodiments, a specific surface area SSA of the silicon-carbon composite material is less than or equal to 5.0 m²/g, and optionally is 0.8 to 4.0 m²/g. In some embodiments, the specific surface area SSA of the silicon-carbon composite material may be 0.8 m²/g, 1.0 m²/g, 1.5 m²/g, 2 m²/g, 2.5 m²/g, 3 m²/g, 3.5 m²/g, 4 m²/g, 4.5 m²/g, or 5 m²/g. The specific surface area SSA of the silicon-carbon composite material may be a value falling within a range formed by any two of the values listed above. When the specific surface area of the silicon-carbon composite material is excessively large, the performance of the material is impaired. When the specific surface area of the silicon-carbon composite material is excessively small, the specific surface area can hardly be implemented in the silicon-carbon composite material.

In some embodiments, the silicon-carbon composite material includes mesopores inside. Optionally, a pore volume of the mesopores is less than or equal to 0.3 cm³/g, for example, is 0.05 to 0.1 cm³/g. In some embodiments, the pore volume of the mesopores may be 0.05 cm³/g, 0.06 cm³/g, 0.07 cm³/g, 0.08 cm³/g, 0.09 cm³/g, 0.1 cm³/g, 0.15 cm³/g, 0.2 cm³/g, 0.25 cm³/g, or 0.3 cm³/g. The pore volume of the mesopores may be a value falling within a range formed by any two of the values listed above. When the pore volume of the mesopores in the silicon-carbon composite material is excessively small, the reserved expansion space of the silicon-based material will be insufficient, and the cycle performance of the silicon-carbon composite material will be impaired. When the pore volume of the mesopores in the silicon-carbon composite material is excessively large, the volume energy density of the silicon-carbon composite material will be excessively low, the practicability of the material will be reduced. In addition, when the pore volume of the mesopores in the silicon-carbon composite material is excessively large, the compression resistance of the silicon-carbon composite material will be impaired, and the material is not resistant to pressure.

In some embodiments, a mass ratio between elements in the silicon-carbon composite material is Si: C: O = (20 to 55): (40 to 70): (3 to 10).

In some embodiments, a mass ratio between elements in the silicon-carbon composite material is Si: C: O = 20: 70: 10, 30: 65: 5, 40: 55: 5, 55: 42: 3, or 55: 40: 5. The mass ratio between elements, Si: C: O, in the silicon-carbon composite material may be a value falling within a range formed by any two of the values listed above. By optimizing the silicon content, it is ensured that the requirement on the capacity of the silicon-carbon composite material is satisfied. By optimizing the carbon content, it is ensured that the porous carbon is formed effectively, and the subsequently deposited silicon-based material is isolated effectively. By optimizing the oxygen content, the pliability of the porous carbon is ensured, and the stability of connection of the porous carbon to the silicon-based material and the carbon nanotube is ensured.

In some embodiments, a coating layer is further disposed on a surface of the silicon-carbon composite material. Optionally, the coating layer includes at least one of a carbon coating layer, a polymer coating layer, an inorganic salt coating layer, or a metal oxide coating layer.

By forming a coating layer on the surface of the silicon-carbon composite material, it is more convenient to prevent direct contact between the electrolyte solution and the silicon-carbon composite material, and improve the cycle performance. In addition, the coating layer serves a function of cushioning to some extent, and further cushions the expansion and reduces the impact of expansion on the electrode plate. Especially, a carbon coating layer can further improve the conductivity of the silicon carbon material.

A second aspect of this application provides a method for preparing a silicon-carbon composite material, including the following steps:
grafting a functional group and/or a polymer onto a carbon nanotube to obtain a modified carbon nanotube;
mixing the modified carbon nanotube with a resin precursor solution to obtain a mixed solution, where both the functional group and the polymer on the modified carbon nanotube is able to chemically react with the resin precursor to connect the modified carbon nanotube and the resin precursor;
curing the mixed solution to obtain a composite substrate precursor;
carbonizing the composite substrate precursor to obtain a porous carbon-and-carbon nanotube composite substrate; and
depositing a silicon-based material on the porous carbon-and-carbon nanotube composite substrate to obtain a silicon-carbon composite material.

The above method can achieve a silicon-carbon composite material that is superior in compression resistance and conductivity. The method is simple to operate, easily repeatable, and mass-producible in industrial applications.

In some embodiments, the mixed solution further includes a catalyst at a percentage of 0.5% to 30% by mass. Optionally, the catalyst includes one or more of hexamethylenetetramine, ammonium bicarbonate, ammonium carbonate, ammonia, a zinc salt, a copper salt, or a chromium salt. In some embodiments, the mass ratio between the modified carbon nanotube, the catalyst, and the phenolic resin precursor solution may be (0.05 to 8): (3 to 7): (83 to 96.95).

By optimizing the reaction conditions, the time of reaction between the modified carbon nanotube and the resin precursor can be shortened favorably, and the reaction conversion rate is improved.

In some embodiments, the mixing includes: stirring at 20 °C to 60 °C for 1 to 10 hours. In this way, the modified carbon nanotube reacts with the resin precursor in one or more of the following manners: esterification reaction, addition reaction, polyaddition reaction, or polycondensation reaction.

In some embodiments, the functional group includes one or more of carboxyl, hydroxyl, amino, phenyl, or carbonyl. The polymer includes one or more of polyamide, polymethyl methacrylate, or polyhydroxyethyl methacrylate.

By optimizing the types of functional groups and/or polymers grafted onto carbon nanotubes, it is convenient to form a more stable connecting unit between the carbon nanotube and the porous carbon, strengthen the interfacial bonding, and improve the compression resistance of the silicon-carbon composite material.

The functional group grafted onto the carbon nanotube may be used as a curing agent for the resin precursor. Optionally, the functional group may be an acidic or alkaline functional group.

In some embodiments, the curing includes: pre-curing, and full curing. Optionally, the curing includes: pre-curing, pulverizing, and full curing.

By optimizing the curing process, the curing effect is improved, and the internal uniformity of the silicon-carbon composite material is improved.

In some embodiments, the volume distribution diameter Dv₅₀ of the powder obtained by pulverization may be 3 to 15 µm, and optionally 5 to 10 µm.

In some embodiments, the pre-curing is performed at a temperature of 70 °C to 140 °C, and optionally 80 °C to 130 °C; and/or the pre-curing continues for a time period of 3 to 12 hours, and optionally 5 to 10 hours.

By optimizing the temperature and time of pre-curing, the internal uniformity of the silicon-carbon composite material is improved, and the uniformity of pore distribution and pore size is improved.

In some embodiments, the full curing is performed at a temperature of 150 °C to 220 °C, and optionally 160 °C to 200 °C; and/or the full curing continues for a time period of 8 to 20 hours, and optionally 10 to 15 hours.

By optimizing the temperature and time of full curing, the curing effect is improved, and the internal uniformity of the silicon-carbon composite material is improved.

In some embodiments, the full curing is performed in an inert atmosphere. The inert atmosphere may be nitrogen, argon, or the like.

In some embodiments, the carbonization is performed at a temperature of 900 °C to 3000 °C, and optionally 1000 °C to 2000 °C; and/or the carbonization continues for a time period of 2 to 6 hours, and optionally 3 to 5 hours.

By optimizing the temperature and time of carbonization, it is convenient to form a more stable connecting unit between the carbon nanotube and the porous carbon, strengthen the interfacial bonding, and improve the compression resistance of the silicon-carbon composite material.

In some embodiments, the carbonization is performed in an inert atmosphere. The inert atmosphere may be nitrogen, argon, or the like.

In some embodiments, the deposition is performed by a chemical vapor deposition method. Optionally, a deposition gas includes a mixed gas formed by mixing a silane gas with at least one of H₂, N₂, or Ar.

The silicon deposition performed by a chemical vapor deposition method makes it convenient to evenly deposit the silicon-based material in the porous carbon-and-carbon nanotube composite substrate. In addition, the growth of silicon particles is limited by the pore size of the porous carbon, and the chemical vapor deposition method can limit the particle size of the silicon particles to a relatively small value, for example, limit the average particle diameter to 50 nm. On the other hand, the chemical vapor deposition method can implement close bonding between the porous carbon and the deposited silicon-based material, thereby properly limiting the expansion of the silicon material.

In some embodiments, the silane gas includes at least one of monosilane, disilane, trisilane, monochlorosilane, dichlorosilane, or trichlorosilane.

In some embodiments, in the mixed gas, the volume percent of the silane gas may be 5% to 80%, for example, 5%, 15%, 25%, 35%, 45%, 55%, 65%, or 80%. The volume percent of the silane gas may be a value falling within a range formed by any two of the values listed above.

In some embodiments, the flow rate of the mixed gas may be 100 to 400 mL/min, for example, may be 100 mL/min, 150 mL/min, 200 mL/min, 250 mL/min, 300 mL/min, 350 mL/min, or 400 mL/min. The flow rate of the mixed gas may be a value falling within a range formed by any two of the values listed above.

In some embodiments, the deposition temperature may be 400 °C to 1000 °C, for example, may be 400 °C, 450 °C, 500 °C, 550 °C, 600 °C, 650 °C, 700 °C, 750 °C, 800 °C, 850 °C, 900 °C, 950 °C, or 1000 °C. The deposition temperature may be a value falling within a range formed by any two of the values listed above. The deposition time may be 2 to 10 hours, for example, may be 2 h, 3 h, 4 h, 5 h, 6 h, 7 h, 8 h, 9 h, or 10 h. The deposition time may be a value falling within a range formed by any two of the values listed above.

In some embodiments, the resin precursor may be any one of a furan resin precursor, a urea-formaldehyde resin precursor, a pyramine resin precursor, a phenolic resin precursor, an epoxy resin precursor, a polyoxymethylene acrylate resin precursor, or a polyacrylonitrile resin precursor.

The mixing ratio between the carbon nanotube and the resin precursor may be adjusted according to the material design requirement.

In some embodiments, the grafting method includes: performing acid washing or alkali washing by using one or more of nitric acid, sulfuric acid, acetic acid, ammonia water, oxalic acid, or the like. Preferably, the grafting method is to perform acid washing by using an organic acid. A carboxyl group or the like may be grafted onto the carbon nanotube by acid washing. For example, a hydroxyl group is grafted onto the carbon nanotube by performing alkaline washing with ammonia water. Alternatively, another known method may be used to graft a functional group and/or a polymer onto the carbon nanotube, for example, graft polymethyl methacrylate onto the carbon nanotube.

In some embodiments, the preparation method further includes: forming a coating layer on the obtained silicon-carbon composite material.

In some embodiments, the carbon coating layer may be formed by a chemical vapor deposition method. The deposition gas of chemical vapor deposition may be a mixed gas of C₂H₂ and N₂. In the mixed gas, the volume percent of C₂H₂ may be 2% to 40%. The flow rate of mixed gas may be 100 to 300 mL/min. The deposition temperature may be 800 °C to 1000 °C, and the deposition time may be 0.5 to 2 hours.

### [Secondary battery]

A secondary battery is a battery that is reusable through activation of an active material in the battery by charging the battery that has been discharged.

Generally, a secondary battery includes a positive electrode plate, a negative electrode plate, a separator, and an electrolyte. In a charge-and-discharge cycle of the battery, active ions are shuttled between the positive electrode plate and the negative electrode plate by intercalation and deintercalation. The separator is disposed between the positive electrode plate and the negative electrode plate to serve an isolation purpose. The electrolyte serves to conduct ions between the positive electrode plate and the negative electrode plate.

### [Negative electrode plate]

In the secondary battery, a negative electrode plate typically includes a negative current collector and a negative film layer disposed on the negative current collector. The negative film layer includes the silicon-carbon composite material disclosed herein above.

The negative current collector may be a conventional metal foil or a composite current collector (for example, the composite current collector by be formed by disposing a metal material on a polymer substrate). As an example, the negative current collector may be a copper foil.

Further, the negative film layer generally optionally includes a binder, a conductive agent, and other optional agents.

As an example, the conductive agent may be one or more of superconductive carbon, acetylene black, carbon black, Ketjen black, carbon dots, carbon nanotubes, graphene, or carbon nanofibers.

As an example, the binder may be one or more of styrene-butadiene rubber (SBR), water-based acrylic resin (water-based acrylic resin), polyvinylidene difluoride (PVDF), polytetrafluoroethylene (PTFE), poly(ethylene-co-vinyl acetate) (EVA), polyvinyl alcohol (PVA), or polyvinyl butyral (PVB).

As an example, the other optional agents may be a thickener and a dispersant (for example, sodium carboxymethyl cellulose CMC-Na), a PTC thermistor material, or the like.

### [Positive electrode plate]

In a secondary battery, the positive electrode plate typically includes a positive current collector and a positive film layer disposed on the positive current collector. The positive film layer includes a positive active material.

The positive current collector may be a conventional metal foil or a composite current collector (for example, the composite current collector by be formed by disposing a metal material on a polymer substrate). As an example, the positive current collector may be an aluminum foil.

The type of the positive active material is not particularly limited in this application, and may be an active material known in the art for use in a positive electrode of a secondary battery, and may be selected by a person skilled in the art according to practical needs.

As an example, the positive active material may include, but is not limited to, one or more of lithium transition metal oxide, olivine-structured lithium-containing phosphate, or a modified compound thereof. Examples of the lithium transition metal oxide may include but not limited to one or more of lithium cobalt oxide, lithium nickel oxide, lithium manganese oxide, lithium nickel cobalt oxide, lithium manganese cobalt oxide, lithium nickel manganese oxide, lithium nickel cobalt manganese oxide, lithium nickel cobalt aluminum oxide, or a modified compound thereof. Examples of the olivine-structured lithium-containing phosphate include, but are not limited to, one or more of lithium iron phosphate, a composite of lithium iron phosphate and carbon, lithium manganese phosphate, a composite of lithium manganese phosphate and carbon, lithium manganese iron phosphate, or a composite of lithium manganese iron phosphate and carbon, or a modified compound thereof. Such materials are all commercially available.

In some embodiments, the modified compound of each material described above may be a product of modifying the material by doping and/or surface-coating the material.

Further, the positive film layer generally optionally includes a binder, a conductive agent, and other optional agents.

As an example, the conductive agent may be one or more of superconductive carbon, acetylene black, carbon black, Ketjen black, carbon dots, carbon nanotubes, Super P (SP), graphene, and carbon nanofibers.

As an example, the binder may be one or more of styrene-butadiene rubber (SBR), water-based acrylic resin (water-based acrylic resin), polyvinylidene difluoride (PVDF), polytetrafluoroethylene (PTFE), poly(ethylene-co-vinyl acetate) (EVA), polyacrylic acid (PAA), carboxymethyl cellulose (CMC), polyvinyl alcohol (PVA), or polyvinyl butyral (PVB).

### [Separator]

In some embodiments, the secondary battery further includes a separator. The type of the separator is not particularly limited in this application, and may be any well-known porous separator that is highly stable both chemically and mechanically.

In some embodiments, the separator may be made of a material that is at least one selected from glass fiber, non-woven fabric, polyethylene, polypropylene, and polyvinylidene difluoride. The separator may be a single-layer film or a multilayer composite film, without being particularly limited. When the separator is a multilayer composite film, materials in different layers may be identical or different, without being particularly limited.

### [Electrolyte solution]

The secondary battery may include an electrolyte solution. The electrolyte solution serves to conduct ions between the positive electrode and the negative electrode. The electrolyte solution may include an electrolyte salt and a solvent.

As an example, the electrolyte salt may be one or more selected from lithium hexafluorophosphate (LiPF₆), lithium tetrafluoroborate (LiBF₄), lithium perchlorate (LiClO₄), lithium hexafluoroarsenate (LiAsF₆), lithium bisfluorosulfonimide (LiFSI), lithium bistrifluoromethanesulfonimide (LiTFSI), lithium trifluoromethanesulfonate (LiTFS), lithium difluoro(oxalato) borate (LiDFOB), lithium bis(oxalato)borate (LiBOB), lithium difluorophosphate (LiPO₂F₂), lithium difluoro(bisoxalato)phosphate (LiDFOP), or lithium tetrafluoro(oxalato)phosphate (LiTFOP).

As an example, the solvent may be one or more selected from ethylene carbonate (EC), propylene carbonate (PC), ethyl methyl carbonate (EMC), diethyl carbonate (DEC), dimethyl carbonate (DMC), dipropyl carbonate (DPC), methyl propyl carbonate (MPC), ethylene propyl carbonate (EPC), butylene carbonate (BC), fluoroethylene carbonate (FEC), methyl formate (MF), methyl acetate (MA), ethyl acetate (EA), propyl acetate (PA), methyl propionate (MP), ethyl propionate (EP), propyl propionate (PP), methyl butyrate (MB), ethyl butyrate (EB), 1,4-butyrolactone (GBL), sulfolane (SF), methyl sulfonyl methane (MSM), ethyl methyl sulfone (EMS), or (ethylsulfonyl)ethane (ESE).

In some embodiments, the electrolyte solution further includes an additive. For example, the additive may include a negative film-forming additive, a positive film-forming additive, and additives that can improve some performance of the battery, for example, an additive that improves overcharge performance of the battery, an additive that improves high-temperature performance of the battery, and an additive that improves low-temperature performance of the battery, and the like.

In some embodiments, the secondary battery of this application is a lithium-ion secondary battery.

The secondary battery may be prepared by a conventional method in this field. For example, the method for preparing a secondary battery includes: sequentially winding (or stacking) a positive electrode plate, a separator, and a negative electrode plate to obtain a battery cell, where the separator is located between the positive electrode plate and the negative electrode plate to serve a separation function; and then placing the battery cell into an outer package, injecting an electrolyte solution, and performing sealing to obtain a secondary battery.

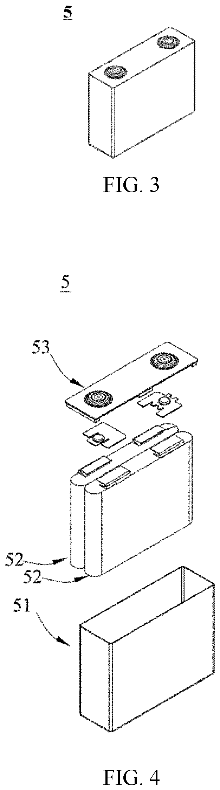

The shape of the secondary battery is not particularly limited in this application, and may be cylindrical, prismatic, or any other shape. FIG. 3 shows a prismatic secondary battery 5 as an example.

In some embodiments, the secondary battery may include an outer package. The outer package is configured to package the positive electrode plate, the negative electrode plate, and the electrolyte solution.

In some embodiments, referring to FIG. 4, the outer package may include a housing body 51 and a cover plate 53. The housing 51 may include a bottom plate and a side plate connected to the bottom plate. The bottom plate and the side plate close in to form an accommodation cavity. An opening that communicates with the accommodation cavity is created on the housing 51. The cover plate 53 can fit and cover the opening to close the accommodation cavity.

The positive electrode plate, the negative electrode plate, and the separator may be made into the electrode assembly 52 by winding or stacking. The electrode assembly 52 is packaged in the accommodation cavity. The electrolyte solution infiltrates in the electrode assembly 52. The number of electrode assemblies 52 in the secondary battery 5 may be one or more, and is adjustable as required.

In some embodiments, the outer package of the secondary battery may be a hard shell such as a hard plastic shell, an aluminum shell, a steel shell, or the like. Alternatively, the outer package of the secondary battery may be a soft package such as a pouch-type soft package. The material of the soft package may be plastic such as one or more of polypropylene (PP), polybutylene terephthalate (PBT), or polybutylene succinate (PBS).

In some embodiments, the secondary battery may be assembled to form a battery module. The battery module may contain a plurality of secondary batteries, and the specific number of the secondary batteries in a battery module may be adjusted according to practical applications and capacity of the battery module.

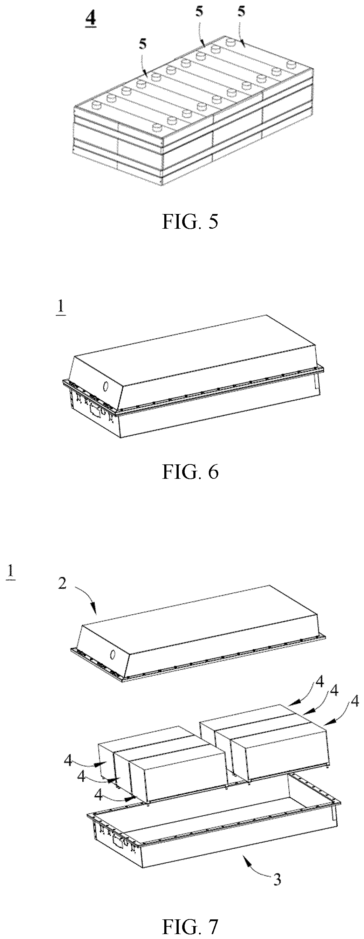

FIG. 5 shows a battery module 4 as an example. In the battery module 4, a plurality of secondary batteries 5 may be arranged sequentially along a length direction of the battery module 4. Alternatively, the secondary batteries may be arranged in any other manner. Further, the plurality of secondary batteries 5 may be fixed by a fastener.

Optionally, the battery module 4 may further include a shell that provides an accommodation space. The plurality of secondary batteries 5 are accommodated in the accommodation space.

In some embodiments, the battery module may be assembled to form a battery pack. The number of the battery modules contained in a battery pack may be adjusted according to practical applications and the capacity of the battery pack.

FIG. 6 and FIG. 7 show a battery pack 1 as an example. The battery pack 1 may contain a battery box and a plurality of battery modules 4 disposed in the battery box. The battery box includes an upper box 2 and a lower box 3. The upper box 2 fits the lower box 3 to form a closed space for accommodating the battery modules 4. The plurality of battery modules 4 may be arranged in the battery box in any manner.

### [Electrical device]

This application further provides an electrical device. The electrical device includes at least one of the secondary battery, the battery module, or the battery pack. The secondary battery, the battery module, or the battery pack may be used as a power supply of the electrical device, or used as an energy storage unit of the electrical device. The device may be, but is not limited to, a mobile device (such as a mobile phone or a laptop computer), an electric vehicle (such as a battery electric vehicle, a hybrid electric vehicle, a plug-in hybrid electric vehicle, an electric bicycle, an electric scooter, an electric golf cart, or an electric truck), an electric train, a ship, a satellite system, or an energy storage system.

The secondary battery, battery module, or battery pack may be selected for use in the electrical device based on the use requirements of the electrical device.

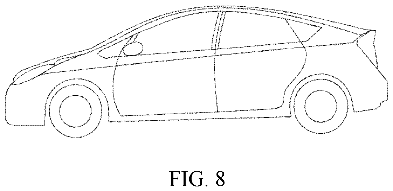

FIG. 8 shows a device as an example. The device may be battery electric vehicle, a hybrid electric vehicle, a plug-in hybrid electric vehicle, or the like. The electrical device may adopt a battery pack or a battery module in order to meet the requirements of the electrical device on a high power and a high energy density of the secondary battery.

In another example, the device may be a mobile phone, a tablet computer, a notebook computer, or the like. The device is generally required to be thin and light, and may have a secondary battery as a power supply.

The beneficial effects of this application are further described below with reference to embodiments.

### Embodiments

To make the technical problems to be solved by this application, technical solutions, and beneficial effects of this application clearer, the following describes this application in further detail with reference to embodiments and drawings. Evidently, the described embodiments are merely a part of but not all of the embodiments of this application. The following description of at least one exemplary embodiment is merely illustrative, and is in no way intended as a limitation on this application or the use thereof. All other embodiments derived by a person of ordinary skill in the art based on the embodiments of this application without making any creative efforts still fall within the protection scope of this application.

All materials used in an embodiment of this application are commercially available.

Preparing a silicon-carbon composite material

### Embodiment 1

### (1) Preparing modified carbon nanotubes

Preparing a carbon nanotube raw material to prepare single-walled carbon nanotubes with a diameter of 2 nm and a length of 35 µm.

Acid-washing the carbon nanotubes with acetic acid to graft a carboxyl functional group onto the carbon nanotube to obtain modified carbon nanotubes.

### (2) Preparing a carbon nanotube-and-porous carbon composite substrate

Mixing the prepared modified carbon nanotubes, an ammonium bicarbonate catalyst, and a phenolic resin precursor solution at a mass ratio of 2%: 5%: 93% (expressed as "ingredient mass ratio" in Table 1). Stirring 60 °C for 1 hour to obtain a mixed solution A, in which the carboxyl functional group on the modified carbon nanotube chemically reacts with the phenolic resin precursor to connect the modified carbon nanotube and the phenolic resin precursor.

Putting the mixed solution A into an 80 °C oven in which the mixed solution A is pre-cured for 10 hours. Pulverizing the pre-cured material to obtain powder B. Controlling the volume distribution diameter Dv₅₀ of the powder B to be 7 µm by controlling the pulverization strength and the jet mill (the air flow rate is 1 m³/min, the classification wheel frequency 45 HZ, the induced draft fan frequency is 40 HZ, the pulverizing air pressure is 0.8 MPa, and the feeding speed is 1 kg/h).

Putting the powder B into the oven, passing nitrogen into the oven for protection, and fully curing the powder at 160 °C for 15 hours to obtain powder C.

Putting the powder C into a muffle oven. Passing nitrogen into the muffle oven for protection, and carbonizing the powder at 1100 °C for 4 hours to form powder D, that is, a carbon nanotube-and-porous carbon composite substrate.

### (3) Depositing nano-silicon-based particles

Performing chemical vapor deposition on the powder D to deposit silicon, where the deposition gas is a mixed gas of monosilane and H₂, the volume percent of the monosilane is 20%, the flow rate of the mixed gas is 400 mL/min, the deposition temperature is 500 °C, and the deposition time is 10 h. The volume distribution diameter Dv₅₀ of the deposited nano-silicon-based particles is 10 nm. A silicon-carbon composite material is obtained upon completion of this step.

### (4) Preparing a coating layer

Performing chemical vapor deposition on the silicon-carbon composite material to form a carbon coating layer, where the deposition gas of the chemical vapor deposition is a mixed gas of C₂H₂ and N₂, the volume percent of C₂H₂ is 20%, the flow rate of the gas passed in is 300 mL/min, the deposition temperature is 800 °C, and the deposition time is 0.5 h. A silicon-carbon composite material coated with a carbon coating layer on the surface is obtained upon completion of this step.

### Embodiments 2 to 18

The operation method in Embodiments 2 to 18 is similar to the method described in Embodiment 1 except that the parameter values are different from those in Embodiment 1, as shown in Table 1.

### Comparative Embodiment 1

The operation method in Comparative Embodiment 1 is substantially the same as the method described in Embodiment 1 except that no carbon nanotubes are added in a process of synthesizing the carbon substrate, but the phenolic resin precursor is directly used for reaction, and the silicon-carbon composite material of Comparative Embodiment 1 is obtained by pre-curing, pulverizing, full curing, carbonization, and nano-silicon-based particle deposition.

### Comparative Embodiment 2

Adding nano-silicon powder (the volume distribution diameter Dv₅₀ is 50 nm) and the modified carbon nanotubes to a phenolic resin precursor for polymerization reaction, and then performing pre-curing, pulverization, full curing, and carbonization to obtain the silicon-carbon composite material of Comparative Embodiment 2. The relevant process conditions are the same as those in Embodiment 1 except that the nano-silicon powder is used rather than depositing the nano-silicon-based particles.

### Comparative Embodiment 3

Mixing the silicon-carbon composite material obtained in Comparative Embodiment 1, carbon nanotubes (with a diameter of 2 nm and a length of 25 µm), and a small amount of phenolic resin precursor solution at a mass ratio of 92.05%: 1.95%: 6%. Performing pre-curing, pulverization, full curing, and carbonization according to the same process flow as Embodiment 1 to obtain a silicon-carbon composite material coated with CNT on the surface, that is, a silicon-carbon composite material of Comparative Embodiment 3. In Comparative Embodiment 3, the silicon-carbon composite material is obtained by wrapping the product of Comparative Example 1 with the modified carbon nanotubes.

**Table 1**

| Serial number | Material preparation process | | | | |
|---|---|---|---|---|---|
| | Preparing modified carbon nanotubes | | Preparing carbon nanotube-and-porous carbon composite substrate | Nano-silicon-based particles | |
| | Length of carbon nanotubes (µm) | Type of modified substance | Ingredient mass ratio | Deposition temperature | Average diameter of nano-silicon-based particle (nm) |
| Embodiment 1 | 35 | Acetic acid | 2%: 5%: 93% | 500 °C | 10 |
| Embodiment 2 | 35 | Ammonia water | 2%: 5%: 93% | 500 °C | 10 |
| Embodiment 3 | 35 | Polymethylmethacrylate | 2%: 5%: 93% | 500 °C | 10 |
| Embodiment 4 | 35 | Acetic acid | 0.1%: 5%: 94.9% | 500 °C | 10 |
| Embodiment 5 | 35 | Acetic acid | 0.2%: 5%: 94.8% | 500 °C | 10 |
| Embodiment 6 | 35 | Acetic acid | 1%: 5%: 94% | 500 °C | 10 |
| Embodiment 7 | 35 | Acetic acid | 5%: 5%: 90% | 500 °C | 10 |
| Embodiment 8 | 35 | Acetic acid | 8%: 5%: 87% | 500 °C | 10 |
| Embodiment 9 | 35 | Acetic acid | 10%: 5%: 85% | 500 °C | 10 |
| Embodiment 10 | 22 | Acetic acid | 2%: 5%: 93% | 500 °C | 10 |
| Embodiment 11 | 50 | Acetic acid | 2%: 5%: 93% | 500 °C | 10 |
| Embodiment 12 | 65 | Acetic acid | 2%: 5%: 93% | 500 °C | 10 |
| Embodiment 13 | 80 | Acetic acid | 2%: 5%: 93% | 500 °C | 10 |
| Embodiment 14 | 35 | Acetic acid | 2%: 5%: 93% | 450 °C | 3 |
| Embodiment 15 | 35 | Acetic acid | 2%: 5%: 93% | 550 °C | 20 |
| Embodiment 16 | 35 | Acetic acid | 2%: 5%: 93% | 600 °C | 30 |
| Embodiment 17 | 35 | Acetic acid | 2%: 5%: 93% | 650 °C | 40 |
| Embodiment 18 | 35 | Acetic acid | 2%: 5%: 93% | 700 °C | 50 |
| Comparative Embodiment 1 | - | - | 0%: 5%: 95% | 500 °C | 10 |
| Comparative Embodiment 2 | 35 | Acetic acid | 2%: 5%: 93% | - | 50 |
| Comparative Embodiment 3 | 35 | - | - | - | 10 |

A secondary battery is prepared according to the following general preparation method by using the silicon-carbon composite material prepared in each embodiment and comparative embodiment described above.

### Preparing a secondary battery

### Preparing a negative electrode plate:

Mixing well the silicon-carbon composite material prepared in each embodiment and comparative embodiment described above, artificial graphite, a binder styrene-butadiene rubber (SBR), a binder polyacrylic acid (PAA), a dispersant (CMC-Na), conductive carbon black (Super-P, SP), and carbon nanotubes (CNT) in an appropriate amount of deionized water at a mass ratio of 10%: 85%: 2%: 1%: 1%: 0.7%: 0.3% to obtain a negative electrode slurry. Applying the negative electrode slurry onto a current collector copper foil by using an applicator, and then performing drying, cold pressing, and slitting to obtain a negative electrode plate.

Preparing a positive electrode plate: Dissolving LiNi_{0.8}Co_{0.1}Mn_{0.1}O₂ (NCM811) as a positive active material, a binder polyvinylidene difluoride (PVDF), and a conductive agent acetylene black in an N-methyl-pyrrolidone (NMP) solvent at a mass ratio of 97%: 1.5%: 1.5%, and stirring and mixing the ingredients well to obtain a positive electrode slurry. Applying the positive electrode slurry on a positive current collector aluminum foil evenly, and then performing drying, cold pressing, and slitting to obtain a positive electrode plate.

Preparing an electrolyte solution: Mixing ethylene carbonate (EC), ethyl methyl carbonate (EMC), and diethyl carbonate (DEC) at a volume ratio of 1: 1: 1, and dissolving LiPF₆ in the forgoing solution evenly to obtain an electrolyte solution. In the electrolyte solution, the concentration of the LiPF₆ is 1 mol/L.

Preparing a secondary battery: Stacking the positive electrode plate, the separator, and the negative electrode plate in sequence, and winding the stacked structure to obtain an electrode assembly. Placing the electrode assembly into an outer package, injecting the electrolytic solution prepared above, and performing steps such as packaging, standing, chemical formation, and aging to obtain a secondary battery.

The porous carbon-and-carbon nanotube composite substrate (that is, powder D) is characterized and tested below.

### 1. Testing the pore volumes of micropores, mesopores, and macropores inside the carbon nanotube-and-porous carbon composite substrate:

A pore volume test process includes: Letting a gaseous adsorbate be adsorbed onto a test material of the composite substrate at a constant temperature and under a series of gradually increasing pressures by using a pore size distribution analyzer TriStarII3020 with reference to the standards GB/T 19587-2017 and GB/T 21650.2-2008. Plotting a curve of the volumes of pores different pore sizes against corresponding partial pressures to characterize the pore size and pore volume distribution of the porous carbon-and-carbon nanotube composite substrate material, and then calculating the average pore diameter. The test results are shown in Table 2 below.

### 2. Testing the mass percent of the carbon nanotubes in the carbon nanotube-and-porous carbon composite substrate:

An exemplary process of testing the content of carbon nanotubes in the carbon nanotube-and-porous carbon composite substrate includes: Putting the carbon nanotube-and-porous carbon composite substrate powder into an ion polisher (such as IB-19500CP); letting an ion source ionize the argon gas under a vacuum condition to generate argon ions; and accelerating and focusing the argon ions so that the high-speed argon ions impact the atoms or molecules out of the sample surface to implement ion polishing and enable cross-sectional analysis. Subsequently, putting a cross-section of the sample material, which is obtained by the ion polishing, into a scanning electron microscope (such as ZEISS Sigma 300) for analysis; selecting 30 particles of the carbon nanotube-and-porous carbon composite substrate, and measuring the area percentage of the carbon nanotubes in each particle as far as the carbon material is concerned (excluding the pore area in the cross-section); and averaging out the measured area percentages of the sample particles, and recording the average value as the content of the carbon nanotubes in the carbon nanotube-and-porous carbon composite substrate because the true density of the carbon nanotubes is equivalent to the true density of the porous carbon material and the content of the carbon nanotubes in the composite substrate may be deemed equivalent to the area percentage.

**Table 2**

| Serial number | Pore volume of mesopores (cm³/g) | Pore volume of micropores (cm³/g) | Pore volume of macropores (cm³/g) | Mass percent of carbon nanotubes in carbon nanotube-and-porous carbon composite substrate |
|---|---|---|---|---|
| Embodiment 1 | 0.60 | 0.07 | 0.08 | 4% |
| Embodiment 2 | 0.56 | 0.08 | 0.10 | 4% |
| Embodiment 3 | 0.62 | 0.10 | 0.12 | 4% |
| Embodiment 4 | 0.55 | 0.05 | 0.08 | 0.2% |
| Embodiment 5 | 0.58 | 0.07 | 0.09 | 0.4% |
| Embodiment 6 | 0.62 | 0.09 | 0.11 | 2% |
| Embodiment 7 | 0.59 | 0.10 | 0.10 | 10% |
| Embodiment 8 | 0.56 | 0.12 | 0.13 | 16% |
| Embodiment 9 | 0.54 | 0.14 | 0.15 | 20% |
| Embodiment 10 | 0.62 | 0.06 | 0.05 | 4% |
| Embodiment 11 | 0.60 | 0.08 | 0.07 | 4% |
| Embodiment 12 | 0.58 | 0.09 | 0.09 | 4% |
| Embodiment 13 | 0.55 | 0.12 | 0.11 | 4% |
| Embodiment 14 | 0.60 | 0.07 | 0.08 | 4% |
| Embodiment 15 | 0.60 | 0.07 | 0.08 | 4% |
| Embodiment 16 | 0.60 | 0.07 | 0.08 | 4% |
| Embodiment 17 | 0.60 | 0.07 | 0.08 | 4% |
| Embodiment 18 | 0.60 | 0.07 | 0.08 | 4% |
| Comparative Embodiment 1 | 0.65 | 0.05 | 0.07 | 0% |
| Comparative Embodiment 2 | 0.53 | 0.13 | 0.15 | 4% |
| Comparative Embodiment 3 | 0.65 | 0.05 | 0.07 | 0% |

The silicon-carbon composite material is characterized and tested below.

### 1. Testing the volume distribution diameter Dᵥ₅₀ of the material

Determining Dᵥ₅₀ by using a laser particle size analyzer (such as Malvern Mastersizer 3000) with reference to the standard GB/T 19077.1-2016, where Dv₅₀ is a diameter of the material particles corresponding to a point at which a cumulative volume percentage of measured particles reaches 50% of a total volume of all the sample particles in a volume-based particle size distribution curve viewed from a small-diameter side.

### 2. Testing the volume distribution diameter Dᵥ₅₀ of the compressed material

Compressing the material under specified compression conditions (for example, in this application, the conditions may be: holding the pressure at 300 MPa for 30 seconds and pressing the material for 50 times), and then determining the volume distribution diameter Dv₅₀ of the compressed material according to the above method.

### 3. Measuring the length L of the carbon nanotubes in the silicon-carbon composite material

An exemplary process of measuring the length L of the carbon nanotubes through a cross-sectional SEM image includes: Putting the silicon-carbon composite material powder into an ion polisher (such as IB-19500CP); letting an ion source ionize the argon gas under a vacuum condition to generate argon ions; and accelerating and focusing the argon ions so that the high-speed argon ions impact the atoms or molecules out of the sample surface to implement ion polishing and enable cross-sectional analysis; and then putting a cross-section of the sample material, which is obtained by ion polishing, into a scanning electron microscope (such as ZEISS Sigma 300) for analysis; and measuring the lengths of 30 carbon nanotubes, and recording the average value of the lengths as the length L of the carbon nanotubes. The test results are shown in Table 3 below.

### 4. Measuring the content of the carbon nanotubes in the silicon-carbon composite material

An exemplary process of testing the content of carbon nanotubes in the silicon-carbon composite material includes: Putting the silicon-carbon composite material powder into an ion polisher (such as IB-19500CP); letting an ion source ionize the argon gas under a vacuum condition to generate argon ions; and accelerating and focusing the argon ions so that the high-speed argon ions impact the atoms or molecules out of the sample surface to implement ion polishing and enable cross-sectional analysis; Subsequently, putting a cross-section of the sample material, which is obtained by the ion polishing, into a scanning electron microscope (such as ZEISS Sigma 300) for analysis; selecting 30 particles of the silicon-carbon composite material, and measuring the area percentage of the carbon nanotubes in each particle; and averaging out the measured area percentages of the sample particles, and recording the average value as the content of the carbon nanotubes in the silicon-carbon composite material because the true density of silicon is close to the true density of carbon and the content of the carbon nanotubes in the silicon-carbon composite material may be deemed approximate to the area percentage of the carbon nanotubes in the particles of the silicon-carbon composite material.

### 5. Testing the mass ratio between elements (Si: C: O) in the silicon-carbon composite material

Evaluating the oxygen content in the silicon-carbon composite material by using a cross-sectional EDS energy spectrum with reference to "quantitative analysis using microbeam analysis and energy-dispersive spectroscopy" in the standard GB/T 17359-2012. A specific operation process includes: Putting the sample powder into an ion polisher (such as IB-19500CP); letting an ion source ionize the argon gas under a vacuum condition to generate argon ions; and accelerating and focusing the argon ions so that the high-speed argon ions impact the atoms or molecules out of the sample surface to implement ion polishing and enable cross-sectional analysis; and putting a cross-section of the resulting powder into an energy dispersive X-ray spectrometer (model: OXFORD, for example) to measure the oxygen content at 10 sites on the cross-section of the material, and averaging out the measured values at the sites to obtain the oxygen content of the material.

Evaluating the silicon content in the silicon-carbon composite material by using an inductively coupled plasma emission spectrometer (ICP) with reference to the U.S. Environmental Protection Agency Standard EPA 6010D-2018. A specific operation process includes: Putting the sample powder into a microwave digester (model: CEM-Mars6, for example), digesting the powder to obtain a solution, passing the solution into the ICP instrument (model: ICAP7400, for example), and calculating the silicon content in the material through comparison with the silicon concentration in the standard solution.

Testing the carbon content in the silicon-carbon composite material by using a carbon sulfur analyzer (Dekai HCS-140 infrared carbon sulfur analyzer, for example) with reference to the standard GB/T 20123-2006/ISO 15350:200. A schematic process is: Heating a sample of the material in a high-frequency furnace under an oxygen-rich condition to combust the sample material at a high temperature so that carbon and sulfur are oxidized into a gas of carbon dioxide. Passing the gas into an absorption pool to absorb corresponding infrared radiation, and then converting the absorbed infrared beam into corresponding signals by using a detector, and calculating the carbon content in the material based on the signals. The test results are shown in Table 3 below.

### 6. Testing the porosity of the material

Measuring the true density of the material by using a true density meter (such as AccuPycII1340). A specific operation process is: Weighing out a portion of the material as a sample, placing the sample into a true density tester, sealing the test system, and passing helium gas into the system according to the procedure. Detecting the gas pressure in the sample chamber and the expansion chamber, and calculating the true volume Vᵣ according to the Bohr's law (PV = nRT), and then calculating the true density as: ρᵣ = m/Vᵣ. Measuring the apparent density of the material in the following process: Putting the powder of the material in a specified amount by mass into a cylindrical mold with an inner diameter of 10 mm; and applying a pressure of 200 MPa to obtain an apparent volume V₀ of the corresponding powder, and calculating the apparent density of the material as: ρ₀ = m/V₀.

Calculating the porosity of the material as: P = 1 - ρ₀/ρᵣ × 100%.

The test results are shown in Table 3 below.

### 7. Testing the specific surface area SSA of the silicon-carbon composite material

Testing the specific surface area SSA of the silicon-carbon composite material by using a specific surface area tester (such as TriStar II 3020) with reference to the standard GB/T 19587-2017 *Determination of the Specific Surface Area of Solids by Gas Adsorption Using the BETMethod.* A specific process includes: Measuring the quantity of a gas adsorbed on the surface of a solid at a constant low temperature and under different relative pressures, and then determining the monolayer adsorption capacity of the sample based on the Brunauer-Emmett-Teller (BET) multilayer adsorption theory, and calculating the specific surface area of the solid. The test results are shown in Table 3 below.

### 8. Measuring the average particle diameter of the nano-silicon-based particles in the silicon-carbon composite material

The average particle diameter of the nano-silicon-based particles in the silicon-carbon composite material may be measured with a transmission electron microscope (such as Thermo Fisher F200i S/TEM) (TEM test) by measuring the particle diameters of 100 nano-silicon-based particles and then averaging out the measured values. For irregularly shaped particles, the largest diameter of the particles is recorded as the particle diameter. The test results are shown in Table 3 below.

### 9. Measuring the resistivity of the silicon-carbon composite material under a 4 MPa pressure

Measuring the resistivity with a resistivity tester (such as ST2722 manufactured by Suzhou Jingge Electronic Co., Ltd.), taking 1 gram of powder sample, placing the sample between electrodes of the tester, applying a constant pressure with an electronic press, and maintaining the constant pressure at different levels for different durations ranging from 15 to 25 seconds. Reading the height h (cm) of the sample, the voltage U across the two ends, the current I, and the resistance R (KQ), and the surface area S of the compressed powder sample being equal to 1 cm². Calculating the resistivity of the powder as: δ = S × R × 1000/h, in units of Ω·cm. The test results are shown in Table 3 below.

**Table 3**

| Serial number | D₀ (µm) | D₁ (µm) | Compression resistance index P | Length L of carbon nanotube in silicon-carbon composite material (µm) | Ratio of length L to D₀ | Content of carbon nanotubes in silicon-carbon composite material | Mass ratio between elements Si: C: O in silicon-carbon composite material | Porosity of silicon-carbon composite material | Specific surface area of silicon-carbon composite material (m²/g) | Volume distribution diameter Dv₅₀ of nano-silicon-based particles in silicon-carbon composite material (nm) | Resistivity of silicon-carbon composite material under 4 MPa (Ω·cm) |
|---|---|---|---|---|---|---|---|---|---|---|---|
| Embodiment 1 | 7.5 | 7.1 | 18.8 | 25 | 3.3 | 2.0% | 45: 50: 5 | 20% | 4 | 10 | 0.25 |
| Embodiment 2 | 7.5 | 7.2 | 25.0 | 25 | 3.3 | 2.0% | 45: 47: 8 | 20% | 4 | 10 | 0.35 |
| Embodiment 3 | 7.5 | 7.3 | 37.5 | 25 | 3.3 | 2.0% | 45: 45: 10 | 20% | 4 | 10 | 0.35 |
| Embodiment 4 | 7.5 | 6.6 | 8.3 | 25 | 3.3 | 0.1% | 45: 50: 5 | 20% | 4 | 10 | 0.39 |
| Embodiment 5 | 7.5 | 6.7 | 9.4 | 25 | 3.3 | 0.2% | 45: 50: 5 | 20% | 4 | 10 | 0.40 |
| Embodiment 6 | 7.5 | 6.8 | 10.7 | 25 | 3.3 | 1.0% | 45: 50: 5 | 20% | 4 | 10 | 0.33 |
| Embodiment 7 | 7.5 | 7.2 | 25 | 25 | 3.3 | 5.0% | 45: 50: 5 | 20% | 4 | 10 | 0.20 |
| Embodiment 8 | 7.5 | 7.3 | 37.5 | 25 | 3.3 | 8.0% | 45: 50: 5 | 20% | 4 | 10 | 0.13 |
| Embodiment 9 | 7.5 | 6.9 | 12.5 | 25 | 3.3 | 10.0% | 45: 50: 5 | 20% | 4 | 10 | 0.09 |
| Embodiment 10 | 7.5 | 7 | 15 | 15 | 2.0 | 2.0% | 45: 50: 5 | 20% | 4 | 10 | 0.32 |
| Embodiment 11 | 7.5 | 7.2 | 25 | 35 | 4.7 | 2.0% | 45: 50: 5 | 20% | 4 | 10 | 0.23 |
| Embodiment 12 | 7.5 | 7.3 | 37.5 | 45 | 6.0 | 2.0% | 45: 50: 5 | 20% | 4 | 10 | 0.19 |
| Embodiment 13 | 7.5 | 7.4 | 75 | 55 | 7.3 | 2.0% | 45: 50: 5 | 20% | 4 | 10 | 0.15 |
| Embodiment 14 | 7.5 | 6.9 | 12.5 | 25 | 3.3 | 2.0% | 45: 50: 5 | 20% | 4 | 3 | 0.21 |
| Embodiment 15 | 7.5 | 7.2 | 25 | 25 | 3.3 | 2.0% | 45: 50: 5 | 20% | 4 | 20 | 0.29 |
| Embodiment 16 | 7.5 | 7.3 | 37.5 | 25 | 3.3 | 2.0% | 45: 50: 5 | 20% | 4 | 30 | 0.33 |
| Embodiment 17 | 7.5 | 7.4 | 75 | 25 | 3.3 | 2.0% | 45: 50: 5 | 20% | 4 | 40 | 0.38 |
| Embodiment 18 | 7.5 | 6.8 | 10.7 | 25 | 3.3 | 2.0% | 45: 50: 5 | 20% | 4 | 50 | 0.43 |
| Comparative Embodiment 1 | 7.5 | 4.5 | 2.5 | - | - | - | 45: 50: 5 | 20% | 4 | 10 | 70 |
| Comparative Embodiment 2 | 7.5 | 4.3 | 2.3 | 25 | 3.3 | 2.0% | 45: 50: 5 | 20% | 4 | 50 | 5 |
| Comparative Embodiment 3 | 7.5 | 4.7 | 2.7 | 25 | 3.3 | 2.0% | 45: 50: 5 | 20% | 4 | 10 | 2 |

The electrical performance of the secondary battery is characterized below.

### Testing the 45 °C cycle performance:

Charging a fresh secondary battery at a constant temperature of 45 °C and at a constant current of 1 C until the voltage reaches 4.25 V, and then charging the battery at a constant voltage of 4.25 V until the current is less than or equal to 0.05 mA. Leaving the battery to stand for 5 minutes, and then discharging the battery at a constant current of 1 C until the voltage reaches 2.5 V, and leaving the battery to stand for 5 minutes, thereby completing one cycle of charge and discharge. Recording the discharge capacity at this time as 1^{st}-cycle discharge capacity of the secondary battery. Charging and discharging the secondary battery for 300 cycles according to the foregoing method, and recording the 300^{th}-cycle discharge capacity.

Calculating the capacity retention rate of the secondary battery after 300 cycles at 45 °C as: CR 45 °C = (300^{th}-cycle discharge capacity/1^{st}-cycle discharge capacity × 100%. The test results are shown in Table 4 below.

### Testing the cycle expansion performance of the secondary battery at 45 °C:

Recording the thickness of the negative electrode plate of the secondary battery upon completion of the cold-pressing process as h₀. Performing the above cycle performance test method of the secondary battery at 45 °C for 300 cycles. Charging the battery at a constant current of 1 C rate until the voltage reaches 4.25 V, and then charging the battery at a constant voltage of 4.25 V until the current is less than or equal to 0.05 mA, and then leaving the battery to stand for 5 minutes. Disassembling the cycled battery cell in a drying room, recording the thickness of the negative electrode plate after 300 cycles as h₃₀₀. Calculating the 300-cycle expansion rate Δh₃₀₀ of the secondary battery at 45 °C as: Δh₃₀₀ (%) = (h₃₀₀ - h₀)/h₀ × 100%. The test results are shown in Table 4 below.

### Rate performance test method:

Charging a fresh secondary battery at a constant current of 0.33 C (that is, a current by which the nominal capacity of the battery is fully discharged within 3 hours) and at a temperature of 25 °C until the voltage reaches a cut-off voltage 4.25 V, and then charging the battery at a constant voltage until the current reaches 0.05 C. Leaving the battery to stand for 5 minutes. Discharging the battery at a constant current of 0.33 C until the voltage reaches a cut-off voltage 2.5 V, and recording an actual capacity of the battery as C₀.

Subsequently, charging the battery at a constant current of 0.33 C until a cut-off voltage 4.25 V, and then charging the battery at a constant voltage until the current reaches 0.05 C. Leaving the battery to stand for 5 minutes, and then discharging the battery at a constant current of 3 C until a cut-off voltage 2.5 V. Recording the actual capacity of the battery as C₃.

The rate performance of the secondary battery may be characterized as DR = C₃/C₀ × 100%. The higher the DR value, the higher the rate performance of the material. The test results are shown in Table 4 below.

The test results are shown in Table 4 below.

**Table 4**

| Embodiment | Capacity retention rate CR 45 °C | Cycle expansion rate Δh₃₀₀ | Rate performance DR |
|---|---|---|---|
| Embodiment 1 | 96.1% | 35.3% | 83.3% |
| Embodiment 2 | 95.5% | 35.8% | 82.6% |
| Embodiment 3 | 95.8% | 34.8% | 82.1% |
| Embodiment 4 | 94.3% | 37.1% | 80.2% |
| Embodiment 5 | 94.9% | 36.5% | 81.4% |
| Embodiment 6 | 95.4% | 35.9% | 81.9% |
| Embodiment 7 | 96.5% | 34.8% | 83.7% |
| Embodiment 8 | 96.9% | 34.4% | 83.9% |
| Embodiment 9 | 96.3% | 35.5% | 82.4% |
| Embodiment 10 | 94.3% | 36.9% | 80.8% |
| Embodiment 11 | 96.7% | 34.7% | 83.9% |
| Embodiment 12 | 97.1% | 34.2% | 84.3% |
| Embodiment 13 | 97.3% | 33.8% | 84.7% |
| Embodiment 14 | 96.9% | 34.2% | 84.1% |
| Embodiment 15 | 95.3% | 35.9% | 82.7% |
| Embodiment 16 | 94.8% | 36.5% | 81.4% |
| Embodiment 17 | 94.2% | 37.1% | 80.8% |
| Embodiment 18 | 93.4% | 37.7% | 80.3% |
| Comparative Embodiment 1 | 88.3% | 42.7% | 75.8% |
| Comparative Embodiment 2 | 82.5% | 47.2% | 77.4% |
| Comparative Embodiment 3 | 89.5% | 40.5% | 78.1% |

As can be seen from the relevant data in Table 4, after the secondary batteries containing the silicon-carbon composite materials in Embodiments 1 to 18 complete 300 cycles at 45 °C, the capacity retention rate is 93.4% to 97.3%, the cycle expansion rate Δh₃₀₀ is 33.8% to 37.7%, the rate performance DR is 80.2% to 84.7%, and the secondary batteries exhibit good cycle stability, small cycle expansion, and good kinetic performance. The silicon-carbon composite material in Comparative Embodiment 1 contains no CNT, and therefore, after the secondary battery completes 300 cycles at 45 °C, the capacity retention rate is 88.3%, the cycle expansion rate Δh₃₀₀ is 42.7%, and the rate performance DR is 75.8%. The silicon-carbon composite material in Comparative Embodiment 2 employs 50 nm nano-silicon powder rather than deposited nano-silicon-based particles, and therefore, after the secondary battery completes 300 cycles at 45 °C, the capacity retention rate is 82.5%, the cycle expansion rate Δh₃₀₀ is 47.2%, and the rate performance DR is 77.4%. The silicon-carbon composite material in Comparative Embodiment 3 is prepared by coating the silicon-carbon material substrate in Comparative Embodiment 1 with CNTs, and therefore, after the secondary battery completes 300 cycles at 45 °C, the capacity retention rate is 89.5%, the cycle expansion rate Δh₃₀₀ is 40.5%, and the rate performance DR is 78.1%. The cycle performance, cycle expansion performance, and the kinetic performance of the secondary batteries in Comparative Embodiments 1 to 3 are all inferior to Embodiments 1 to 18. Therefore, when the nano-silicon-based material is deposited in the carbon nanotube-and-porous carbon composite substrate in which the porous carbon is connected to carbon nanotubes by a connecting unit, the resulting secondary battery achieves both good cycle performance and a low cycle expansion rate, and is superior in the rate performance.

What is described above is merely exemplary embodiments of the present invention, but is not intended as a limitation on the protection scope of the present invention. Any variations or replacements readily derivable by a person skilled in the art without departing from the technical scope hereof fall within the protection scope of the present invention. Therefore, the protection scope of the present invention is subject to the protection scope of the claims.

## Claims

1. A silicon-carbon composite material, wherein the silicon-carbon composite material comprises a carbon nanotube-and-porous carbon composite substrate and a silicon-based material, and the porous carbon is connected to the carbon nanotube by a connecting unit in the carbon nanotube-and-porous carbon composite substrate.

2. The silicon-carbon composite material according to claim 1, wherein the connecting unit comprises at least one of a carbon-carbon bond, a benzene ring, an ester group, or a carbonyl group.

3. The silicon-carbon composite material according to claim 1 or 2, wherein at least a part of the silicon-based material is distributed in pores of the carbon nanotube-and-porous carbon composite substrate.

4. The silicon-carbon composite material according to any one of claims 1 to 3, wherein one end of at least a part of the carbon nanotubes protrudes from a surface of the silicon-carbon composite material.

5. The silicon-carbon composite material according to any one of claims 1 to 4, wherein a diameter of the carbon nanotube is 0.5 to 20 nm, and optionally, the diameter of the carbon nanotube is 0.7 to 10 nm.

6. The silicon-carbon composite material according to any one of claims 1 to 5, wherein a length of the carbon nanotube is denoted as L, and a volume distribution diameter Dv₅₀ of the silicon-carbon composite material is denoted as D₀, and therefore, the silicon-carbon composite material satisfies: L ≥ 3D₀, and optionally, the silicon-carbon composite material satisfies: 3D₀ ≤ L ≤ 7D₀.

7. The silicon-carbon composite material according to any one of claims 1 to 6, wherein a length-to-diameter ratio of the carbon nanotube is greater than or equal to 900, and optionally is 2500 to 25000.

8. The silicon-carbon composite material according to any one of claims 1 to 7, wherein a content of the carbon nanotubes in the silicon-carbon composite material is less than or equal to 8%, and optionally is 0.2% to 5.0%.

9. The silicon-carbon composite material according to any one of claims 1 to 8, wherein the carbon nanotube-and-porous carbon composite substrate satisfies at least one of the following conditions (1) to (4):
(1) the carbon nanotube-and-porous carbon composite substrate comprises mesopores inside, and optionally, a pore volume of the mesopores is greater than or equal to 0.1 cm³/g, and further optionally is 0.2 to 2.5 cm³/g;
(2) the carbon nanotube-and-porous carbon composite substrate comprises micropores inside, and optionally, a pore volume of the micropores is less than or equal to 0.3 cm³/g, and further optionally is 0.05 to 0.2 cm³/g;
(3) the carbon nanotube-and-porous carbon composite substrate comprises macropores inside, and optionally, a pore volume of the macropores is less than or equal to 0.5 cm³/g, and further optionally is 0.05 to 0.4 cm³/g; and
(4) the carbon nanotube-and-porous carbon composite substrate comprises mesopores and micropores inside, and optionally, a pore volume ratio between the mesopores and the micropores is greater than or equal to 2, and optionally is 3 to 15.

10. The silicon-carbon composite material according to any one of claims 1 to 9, wherein the silicon-based material is nano-silicon-based particles, and optionally, an average particle diameter of the nano-silicon-based particles is less than or equal to 50 nm, and further optionally is 3 to 20 nm.

11. The silicon-carbon composite material according to any one of claims 1 to 10, wherein the silicon-based material comprises at least one of simple-substance silicon, silicon oxide (such as silicon suboxide), a silicon-carbon composite, a silicon-nitrogen composite, a silicon alloy, or a pre-lithiated silicon oxide compound.

12. The silicon-carbon composite material according to any one of claims 1 to 11, wherein the silicon-based material comprises amorphous silicon, and optionally, the silicon-based material comprises a mixture of amorphous silicon and crystalline silicon.

13. The silicon-carbon composite material according to any one of claims 1 to 12, wherein the carbon nanotube-and-porous carbon composite substrate is formed by carbonizing a resin precursor and carbon nanotubes grafted with a functional group and/or a polymer, and both the functional group and the polymer are able to chemically react with the resin precursor to connect the carbon nanotubes and the resin precursor to form the connecting unit after the carbonization.

14. The silicon-carbon composite material according to any one of claims 1 to 13, wherein, when the silicon-carbon composite material or the carbon nanotube-and-porous carbon composite substrate is tested by infrared spectroscopy, the silicon-carbon composite material or the carbon nanotube-and-porous carbon composite substrate comprises at least one of the following connecting units: ester carbonyl with an absorption peak of 1750 to 1735 cm⁻¹, ketone carbonyl with an absorption peak of 1725 to 1705 cm⁻¹, a phenyl ring group with an absorption peak of 1620 to 1450 cm⁻¹, or a carbon-carbon bond with an absorption peak of 2400 to 1950 cm⁻¹; and/or
when the silicon-carbon composite material or the carbon nanotube-and-porous carbon composite substrate is tested by a transmission electron microscope, a region percentage is greater than or equal to 50%, wherein the region percentage is a length percentage of a region meeting the following criterion: an inter-atom spacing of the carbon nanotube in the silicon-carbon composite material or the carbon nanotube-and-porous carbon composite substrate is less than or equal to 0.35 nm, and the inter-atom spacing is a spacing between a carbon atom around the carbon nanotube and a carbon atom in an outermost layer of the carbon nanotube.

15. The silicon-carbon composite material according to any one of claims 1 to 14, wherein a compression resistance index of the silicon-carbon composite material is expressed as P = D₀/(D₀-D₁), and P is greater than or equal to 3, wherein D₀ is a volume distribution diameter Dv₅₀ of the silicon-carbon composite material, D₁ is a volume distribution diameter Dv₅₀ of the silicon-carbon composite material that has been compressed for 50 times, and, in a compression operation performed in each time, the silicon-carbon composite material is compressed under a pressure of 300 MPa for 30 seconds.

16. The silicon-carbon composite material according to any one of claims 1 to 15, wherein a resistivity ρ of the silicon-carbon composite material under a pressure of 4 MPa is less than or equal to 0.4 Ω·cm, and optionally satisfies: 0.05 Ω·cm ≤ ρ ≤ 0.3 Ω·cm.

17. The silicon-carbon composite material according to any one of claims 1 to 16, wherein the silicon-carbon composite material satisfies at least one of the following conditions (I) to (V):
(I) a volume distribution diameter Dv₅₀ of the silicon-carbon composite material is less than or equal to 8 µm, and optionally is 3 to 7 µm;
(II) a porosity of the silicon-carbon composite material is less than or equal to 20%, and optionally is 5% to 15%;
(III) a specific surface area SSA of the silicon-carbon composite material is less than or equal to 5.0 m²/g, and optionally is 0.8 to 4.0 m²/g;
(IV) the silicon-carbon composite material comprises mesopores inside, and optionally, a pore volume of the mesopores is less than or equal to 0.3 cm³/g, and further optionally is 0.05 to 0.1 cm³/g; and
(V) a mass ratio between elements in the silicon-carbon composite material is Si: C: O = (20 to 55): (40 to 70): (3 to 10).

18. The silicon-carbon composite material according to any one of claims 1 to 17, wherein a coating layer is further disposed on a surface of the silicon-carbon composite material, and optionally, the coating layer comprises at least one of a carbon coating layer, a polymer coating layer, an inorganic salt coating layer, or a metal oxide coating layer.

19. A method for preparing a silicon-carbon composite material, comprising the following steps:
grafting a functional group and/or a polymer onto a carbon nanotube to obtain a modified carbon nanotube;
mixing the modified carbon nanotube with a resin precursor solution to obtain a mixed solution, wherein both the functional group and the polymer on the modified carbon nanotube is able to chemically react with the resin precursor to connect the modified carbon nanotube and the resin precursor;
curing the mixed solution to obtain a composite substrate precursor;
carbonizing the composite substrate precursor to obtain a porous carbon-and-carbon nanotube composite substrate; and
depositing a silicon-based material on the porous carbon-and-carbon nanotube composite substrate to obtain a silicon-carbon composite material.

20. The preparation method according to claim 19, wherein the mixed solution further comprises a catalyst at a percentage of 0.5% to 30% by mass, and optionally, the catalyst comprises one or more of hexamethylenetetramine, ammonium bicarbonate, ammonium carbonate, ammonia, a zinc salt, a copper salt, or a chromium salt.

21. The preparation method according to claim 19 or 20, wherein the mixing comprises: stirring at 20 °C to 60 °C for 1 to 10 hours so that the modified carbon nanotube reacts with the resin precursor in one or more of the following manners: esterification reaction, addition reaction, polyaddition reaction, or polycondensation reaction.

22. The preparation method according to any one of claims 19 to 21, wherein the functional group comprises one or more of carboxyl, hydroxyl, amino, phenyl, or carbonyl; and/or
the polymer comprises one or more of polyamide, polymethyl methacrylate, or polyhydroxyethyl methacrylate.

23. The preparation method according to any one of claims 19 to 22, wherein
the curing comprises: pre-curing, and full curing; and
optionally, the curing comprises: pre-curing, pulverizing, and full curing.

24. The preparation method according to any one of claims 19 to 23, wherein
the pre-curing is performed at a temperature of 70 °C to 140 °C, and optionally 80 °C to 130 °C; and/or
the pre-curing continues for a time period of 3 to 12 hours, and optionally 5 to 10 hours.

25. The preparation method according to any one of claims 19 to 24, wherein
the full curing is performed at a temperature of 150 °C to 220 °C, and optionally 160 °C to 200 °C; and/or
the full curing continues for a time period of 8 to 20 hours, and optionally 10 to 15 hours.

26. The preparation method according to any one of claims 19 to 25, wherein
the carbonization is performed at a temperature of 900 °C to 3000 °C, and optionally 1000 °C to 2000 °C; and/or
the carbonization continues for a time period of 2 to 6 hours, and optionally 3 to 5 hours.

27. The preparation method according to any one of claims 19 to 26, wherein the deposition is performed by a chemical vapor deposition method, and optionally, a deposition gas comprises a mixed gas formed by mixing a silane gas with at least one of H₂, N₂, or Ar.

28. A secondary battery, comprising a negative electrode plate, wherein the negative electrode plate comprises the silicon-carbon composite material according to any one of claims 1 to 18 or a silicon-carbon composite material prepared by the preparation method according to any one of claims 19 to 27.

29. An electrical device, comprising the secondary battery according to claim 28.
